# EUROPEAN PATENT APPLICATION

(11) **EP 4 651 213 A1**
(43) Date of publication of application: **19.11.2025**
(21) Application number: 24778274.1
(22) Date of filing: 29.03.2024
(51) Int. Cl.: H01L 33/50, H01L 33/52, H01L 33/54, H01L 25/075, G09F 9/33

(54) **DISPLAY PANEL AND ELECTRONIC DEVICE**

(30) Priority: 31.03.2023 CN 202310364277
(71) Applicant: Huawei Technologies Co., Ltd., Shenzhen, Guangdong 518129 (CN)
(72) Inventor: YANG, Lei, Shenzhen, Guangdong 518129 (CN); ZHANG, Li, Shenzhen, Guangdong 518129 (CN); YANG, Yina, Shenzhen, Guangdong 518129 (CN); LIANG, Chaorong, Shenzhen, Guangdong 518129 (CN)
(74) Representative: Maiwald GmbH
(86) International application number: PCT/CN2024/085029
(87) International publication number: WO 2024/199489

(57) **Abstract**

This application provides a display panel, including a substrate, a backlight module, a color conversion module, and an encapsulation module that are sequentially stacked. The backlight module includes a plurality of LED light-emitting units that are spaced, and a dimension of each LED light-emitting unit ranges from 1 µm to 50 µm. The color conversion module includes a plurality of quantum dot units that are disposed in a one-to-one correspondence with the plurality of LED light-emitting units, and each quantum dot unit is configured to convert a wavelength of light emitted by a corresponding LED light-emitting unit. The encapsulation module includes an encapsulation layer and a buffer layer. The encapsulation layer covers the color conversion module. The buffer layer is located between the encapsulation layer and the color conversion module. A size of the buffer layer is greater than a size of the plurality of quantum dot units. The buffer layer is configured to protect the plurality of quantum dot units. In this application, the buffer layer is used to separate the quantum dot unit and the encapsulation layer in the display panel, to improve light-emitting efficiency of the quantum dot unit and improve display effect of the display panel. This application further provides an electronic device.

## Description

This application claims priority to Chinese Patent Application No. 202310364277.1, filed with the China National Intellectual Property Administration on March 31, 2023 and entitled "DISPLAY PANEL AND ELECTRONIC DEVICE", which is incorporated herein by reference in its entirety.

### TECHNICAL FIELD

This application relates to the field of electronic device technologies, and in particular, to a display panel and an electronic device having the display panel.

### BACKGROUND

As a type of high-light-efficiency material, a quantum dot is characterized by high luminous efficiency and extremely high color saturation, and therefore attracts wide attention in the industry. On a display panel designed by using a quantum dot light-emitting technology, a plurality of LED light-emitting units are disposed and correspond to quantum dot units, light emitted by the LED excites a material of the quantum dot unit to emit light, and a wavelength of the light is converted, to form different colors, so as to implement full-color display of the display panel. An encapsulation module further needs to be mounted on a surface of the quantum dot unit for encapsulation protection, to prevent water and oxygen in an environment from eroding each functional structure inside the display panel.

The quantum dot material is not resistant to water and oxygen. When the quantum dot material reacts with water and oxygen, a charged state is generated. This greatly reduces light efficiency of the quantum dot material. Therefore, an encapsulation process needs to be performed. An encapsulation process of the quantum dot unit usually includes a metal-organic precursor or plasma bombardment. A chemical reaction occurs between the metal-organic precursor and a surface of the quantum dot, causing surface damage and ligand dissociation of the quantum dot material. This reduces light-emitting efficiency and light-emitting effect of the quantum dot unit, and affects working stability of the quantum dot unit. In addition, high-energy plasma leads to a free radical reaction. This directly causes irreversible damage to the quantum dot material. Performance degradation of the quantum dot unit directly affects picture display effect of the display panel, and reduces user experience.

### SUMMARY

This application provides a display panel. A structure of an encapsulation module is optimized in a targeted manner, so that working stability of a quantum dot unit can be improved, device encapsulation effect can be enhanced, and picture display effect of the display panel can be improved. This application further provides an electronic device having the display panel. This application specifically includes the following technical solutions.

According to a first aspect, this application provides a display panel. The display panel includes a substrate, a backlight module, a color conversion module, and an encapsulation module that are sequentially stacked. The backlight module includes a plurality of LED light-emitting units that are spaced, and a dimension of each LED light-emitting unit ranges from 1 µm to 50 µm. The color conversion module includes a plurality of quantum dot units, the plurality of quantum dot units are disposed in a one-to-one correspondence with the plurality of LED light-emitting units, and each quantum dot unit is configured to convert a wavelength of light emitted by a corresponding LED light-emitting unit. The encapsulation module includes an encapsulation layer and a buffer layer. The encapsulation layer covers the color conversion module. The buffer layer is located between the encapsulation layer and the color conversion module. A size of the buffer layer is greater than a size of the plurality of quantum dot units. The buffer layer is configured to protect the plurality of quantum dot units.

On the display panel in this application, the plurality of LED light-emitting units are disposed, and a dimension of each LED light-emitting unit is set to ranging form 1 µm (micrometer) to 50 µm, so that a PPI (Pixel Per Inch) of the arranged LED light-emitting unit can be improved. The plurality of quantum dot units are disposed in a one-to-one correspondence with the plurality of LED light-emitting units, that is, each quantum dot unit corresponds to one LED light-emitting unit, so that light emitted by the LED light-emitting unit can be emitted to the quantum dot unit. In addition, each quantum dot unit is excited to convert a wavelength of light emitted by a corresponding LED light-emitting unit. Light of different wavelengths is emitted outward to form different light-emitting colors, to implement effect of displaying a full-color picture by the display panel. The substrate is disposed on the display panel, so that each functional structure in the display panel can be supported and fastened, so that each functional structure in the display panel can work normally. For a feature that high-pixel luminance is applied to an electronic device like augmented reality (Augmented Reality, AR), virtual reality (Virtual Reality, VR), or near-eye display, an encapsulation process is critical. An encapsulation module structure is designed, so that encapsulation effect of the display panel can be improved, and a product service life of a micro display panel can be prolonged.

In the encapsulation module of the display panel in this application, the buffer layer is disposed between the color conversion module and the encapsulation layer, the buffer layer is disposed to separate the quantum dot unit and the encapsulation layer, and the size of the buffer layer is set to be greater than the size of the plurality of quantum dot units, so that the buffer layer can separate the color conversion module and the encapsulation layer. In this way, each quantum dot unit is protected. This avoids surface damage and ligand detachment of a quantum dot material in the quantum dot unit caused by a chemical reaction between a metal-organic precursor corresponding to the encapsulation layer and the quantum dot material when the encapsulation layer is subsequently prepared, reducing light-emitting efficiency and light-emitting effect of the quantum dot unit, and reducing stability and effectiveness of the quantum dot unit. The buffer layer is disposed between the color conversion module and the encapsulation layer, so that flattening effect can be implemented on a surface that is of each quantum dot unit and that is away from the substrate, to facilitate subsequent preparation of another film layer, and improve preparation effect and quality of the another film layer.

In this application, the encapsulation layer is disposed on the display panel to cover the buffer layer, and the size of the buffer layer is set to be greater than the size of the plurality of quantum dot units, so that a function of encapsulating the display panel by the encapsulation module can be implemented, to prevent water and oxygen from eroding each functional structure in the display panel. In this way, a water vapor transmission rate (Water Vapor Transmission Rate, WVTR) of the display panel is less than 5×10⁻⁶ g/m²/day. In other words, the quantum dot unit is protected by the buffer layer, and the display panel is encapsulated by using the encapsulation layer, to prevent the quantum dot unit and another functional structure in the display panel from being eroded by water and oxygen, so that stability and effectiveness of the quantum dot unit can be ensured, picture display effect of the display panel is improved, and user experience is further improved.

In a possible implementation, the encapsulation layer includes a first encapsulation layer, a size of the first encapsulation layer is greater than the size of the buffer layer, and an edge that is of the first encapsulation layer and that exceeds the buffer layer is attached to the color conversion module.

In a possible implementation, the buffer layer is attached to each quantum dot unit.

In a possible implementation, a material of the buffer layer is any one of polymethylmethacrylate, epoxy resin, polyethylene terephthalate, polyethylene naphthalate, PAVC, poly-p-xylylene, PCPX, polyimide, polystyrene, pichlorodi-p-xylylene, amorphous fluoropolymer fluorine resin, dichloroxylene dimer, parylene AF4, lithium fluoride, titanium dioxide, silicon dioxide or pyramid dioxide.

In a possible implementation, the first encapsulation layer is prepared through an atomic layer deposition process or a sputtering process.

In this implementation, the first encapsulation layer is prepared through an atomic layer deposition process or a sputtering process, so that structural density of the first encapsulation layer can be improved, and encapsulation effect of the first encapsulation layer can be improved. This improves working stability and working effect of the quantum dot unit, to improve picture display effect and display stability of the display panel.

In a possible implementation, a thickness of the first encapsulation layer ranges from 20 nm (nanometer) to 200 nm.

In a possible implementation, a thickness of the buffer layer ranges from 30 nm to 5 µm.

In a possible implementation, the encapsulation module includes a second encapsulation layer, and the second encapsulation layer is attached to a side that is of the first encapsulation layer and that is away from the buffer layer. A size of the second encapsulation layer is greater than the size of the first encapsulation layer, a size of the substrate is greater than a size of the color conversion module, and an edge that is of the second encapsulation layer and that exceeds the first encapsulation layer is attached to the substrate.

In this implementation, the second encapsulation layer is disposed on the side that is of the first encapsulation layer and that is away from the buffer layer, so that the display panel can be further encapsulated, to further improve effect of encapsulating the display panel by the encapsulation module. A projection of the first encapsulation layer on the second encapsulation layer is set to be accommodated in the second encapsulation layer, that is, the size of the second encapsulation layer is set to be greater than the size of the first encapsulation layer, and the edge that is of the second encapsulation layer and that exceeds the first encapsulation layer is attached to the substrate, to further form encapsulate protection on the edge of the first encapsulation layer, and prevent impurities such as water, oxygen, and dust in an external environment from entering the display panel from the edge of the first encapsulation layer.

In a possible implementation, the encapsulation module includes a buffer layer and a second encapsulation layer, and the second encapsulation layer is attached to a surface of the buffer layer.

In a possible implementation, the second encapsulation layer is manufactured in any one of a chemical vapor deposition process and a magnetron sputtering process.

In a possible implementation, a material of the second encapsulation layer is silicon nitride.

In this implementation, a film layer made of silicon nitride has good compactness, and the material of the second encapsulation layer is set to silicon nitride, so that encapsulation effect of the second encapsulation layer can be improved.

In a possible implementation, a thickness of the second encapsulation layer ranges from 200 nm to 4 µm.

In a possible implementation, a size of the backlight module is greater than a size of the color conversion module, and an edge that is of the second encapsulation layer and that exceeds the first encapsulation layer is attached to the backlight module.

In this implementation, the size of the backlight module is set to be greater than the size of the color conversion module, so that the second encapsulation layer can extend to be attached to the backlight module, to completely encapsulate the entire color conversion module. In addition, the second encapsulation layer is attached to the backlight module, so that a vertical distance at which edge water vapor diffuses into the display panel is increased. This helps suppress water and oxygen diffusion, and reduce a water vapor transmission rate of the display panel. This further reduces a risk that the quantum dot unit fails due to water and oxygen erosion, and further improves working stability of the quantum dot unit. The second encapsulation layer is disposed to be attached to the backlight module, so that a guard ring structure can be formed around the display panel, to avoid possible adverse impact of chipping effect on edge encapsulation effect of the encapsulation module in a subsequent process of cutting the display panel.

In a possible implementation, the backlight module includes a driver backplane, a filling layer, and an electrode layer that are stacked. The filling layer is located between the driver backplane and the electrode layer. The LED light-emitting unit is embedded in the filling layer. An edge that is of the second encapsulation layer and that exceeds the first encapsulation layer is attached to the electrode layer.

In this implementation, the second encapsulation layer is disposed to be partially attached to the electrode layer, so that closed space is formed between the second encapsulation layer and the electrode layer, and a functional structure located between the second encapsulation layer and the electrode layer can be completely encapsulated, to further improve encapsulation effect of the encapsulation module. The second encapsulation layer is disposed to be partially attached to the electrode layer, so that a guard ring structure can be formed around the display panel, to increase a vertical distance at which edge water vapor diffuses into the display panel and suppress water and oxygen diffusion, and reduce possible adverse impact of chipping effect on edge encapsulation effect of the encapsulation module in a cutting process of the display panel.

In a possible implementation, a material of the filling layer is silicon dioxide.

In a possible implementation, an edge that is of the second encapsulation layer and that exceeds the first encapsulation layer is attached to the filling layer.

In this implementation, the second encapsulation layer is disposed to be partially attached to the filling layer, so that closed space is formed between the second encapsulation layer and the filling layer, to completely encapsulate a functional structure that is of the display panel and that is located between the second encapsulation layer and the filling layer, and further improve encapsulation effect of the encapsulation module. The second encapsulation layer is disposed to be partially attached to the filling layer, so that a guard ring structure can be formed around the display panel, to increase a vertical distance at which edge water vapor diffuses into the display panel and suppress water and oxygen diffusion, and reduce possible adverse impact of chipping effect on edge encapsulation effect of the encapsulation module in a cutting process of the display panel.

In a possible implementation, a surface that is of the filling layer and that is away from the substrate is flush with a surface that is of the LED light-emitting unit and that is away from the substrate.

In this implementation, the surface that is of the filling layer and that is away from the substrate is disposed to be flush with the surface that is of the LED light-emitting unit and that is away from the substrate, so that bonding effect between the LED light-emitting unit and the driver backplane can be improved. In this way, device efficiency and a yield of the backlight module are improved, and working performance of the backlight module is ensured.

In a possible implementation, an edge that is of the second encapsulation layer and that exceeds the first encapsulation layer is attached to the driver backplane.

In this implementation, the second encapsulation layer is disposed to be partially attached to the driver backplane, so that closed space is formed between the second encapsulation layer and the driver backplane, to completely encapsulate a functional structure that is of the display panel and that is located between the second encapsulation layer and the driver backplane. To be specific, when the second encapsulation layer is attached to the driver backplane, structures such as the plurality of LED light-emitting units, a metal wire arranged on the driver backplane, and a pad (metal bonding layer) configured to be bonded to the LED light-emitting unit can all be synchronously and completely encapsulated. This avoids a reaction like oxidation of the metal wire, the pad, or the like caused by water and oxygen erosion, which affects working reliability of the backlight module. In other words, the second encapsulation layer is disposed to be partially attached to the driver backplane, to implement synchronous encapsulation of the backlight module and the color conversion module, so that encapsulation efficiency and encapsulation effect of the encapsulation module can be further improved. The second encapsulation layer is disposed to be partially attached to the driver backplane, so that a guard ring structure can be formed around the display panel, to increase a vertical distance at which edge water vapor diffuses into the display panel and suppress water and oxygen diffusion, and reduce possible adverse impact of chipping effect on edge encapsulation effect of the encapsulation module in a cutting process of the display panel.

In a possible implementation, an edge that is of the second encapsulation layer and that exceeds the first encapsulation layer is attached to the driver backplane, the filling layer, and the electrode layer at the same time.

In a possible implementation, the color conversion module includes a quantum dot pixel definition layer, each quantum dot unit is embedded in the quantum dot pixel definition layer, a size of the quantum dot pixel definition layer is greater than the size of the first encapsulation layer, and the edge that is of the second encapsulation layer and that exceeds the first encapsulation layer is attached to the quantum dot pixel definition layer.

In this implementation, each quantum dot unit is disposed to be embedded in the quantum dot pixel definition layer, so that the quantum dot units can be spaced from each other. This avoids light crosstalk between adjacent quantum dot units and affects picture display effect of the display panel. Each quantum dot unit is disposed to be embedded in the quantum dot pixel definition layer, so that an inorganic quantum dot pixel definition layer can form pixelized encapsulation effect on a peripheral side of the quantum dot unit. This further improves stability and effectiveness of the quantum dot unit. The size of the quantum dot pixel definition layer is set to be greater than the size of the first encapsulation layer, and the edge that is of the second encapsulation layer and that exceeds the first encapsulation layer is disposed to be attached to the quantum dot pixel definition layer, so that the second encapsulation layer can implement encapsulation effect on the quantum dot pixel definition layer and the first encapsulation layer. In addition, edge encapsulation effect of the display panel is improved.

In a possible implementation, a material of the quantum dot pixel definition layer includes at least one of aluminum, silver, platinum, gold, copper, titanium, nickel, and chromium, and a metal-filled structure with strong heat dissipation helps avoid a high-temperature failure problem of a quantum dot caused by a high junction temperature of the LED.

In this implementation, the quantum dot pixel definition layer is set to be made of a metal material with high reflectivity, so that sidewall light reflectivity of the quantum dot unit can be improved. This improves light-emitting efficiency and light-emitting effect of the display module. Light crosstalk between adjacent quantum dot units is further reduced, and an optical angle is reduced.

In a possible implementation, a size of the substrate is greater than a size of the backlight module, and an edge that is of the second encapsulation layer and that exceeds the first encapsulation layer is attached to the substrate.

In this implementation, the size of the substrate is set to be greater than the size of the backlight module, so that the second encapsulation layer can extend to be attached to the substrate, and the second encapsulation layer can completely encapsulate the color conversion module and the backlight module. A range in which the second encapsulation layer completely encapsulates each functional structure in the display panel is expanded, to further improve encapsulation effect of the encapsulation module and improve working performance of the display panel. The second encapsulation layer is attached to the substrate, so that a guard ring structure can be formed around the display panel, a vertical distance at which edge water vapor diffuses into the display panel is further increased, and impact of subsequent cutting on edge encapsulation of the encapsulation module can be further reduced.

In a possible implementation, the encapsulation module includes a cover assembly. The cover assembly includes an encapsulation cover and a support ring. The encapsulation cover is spaced from the first encapsulation layer and is located on a side that is of the first encapsulation layer and that is away from the buffer layer. The support ring is disposed around a periphery of the first encapsulation layer and supports the encapsulation cover, and the support ring and the encapsulation cover work together to encapsulate the display panel.

In this implementation, the support ring is disposed around the periphery of the first encapsulation layer, so that support effect can be formed on the encapsulation cover, and the encapsulation cover and the first encapsulation layer are spaced from each other, to prevent the encapsulation cover from squeezing the first encapsulation layer. Therefore, encapsulation effect of the first encapsulation layer can be ensured. Through cooperation between the support ring and the encapsulation cover, encapsulation effect can be further formed for the display panel, to further improve encapsulation effect of the encapsulation module on the display panel. The encapsulation cover and the support ring cooperate with each other to further encapsulate the display panel. A preparation process of the structure is simple, process difficulty of the encapsulation module is reduced, and a possible undesirable phenomenon like peeling or fracture of a multi-film layer structure is avoided.

In a possible implementation, the support ring is fastened to the color conversion module.

In this implementation, the support ring is disposed to be fastened to the color conversion module, so that the encapsulation cover and the support ring cooperate with each other to encapsulate the first encapsulation layer and an edge of the first encapsulation layer, so as to further encapsulate the display panel.

In a possible implementation, the support ring is fastened to the backlight module.

In this implementation, the size of the backlight module is set to be greater than the size of the color conversion module, and the support ring is fastened to the backlight module, so that the encapsulation cover and the support ring cooperate with each other to completely encapsulate the entire color conversion module. This further reduces a risk that the quantum dot unit fails due to water and oxygen erosion. In this way, working stability of the quantum dot unit is improved.

In a possible implementation, the support ring is fastened to the driver backplane.

In a possible implementation, the support ring is fastened to the filling layer.

In a possible implementation, the support ring is fastened to the electrode layer.

In a possible implementation, the support ring is fastened to the substrate.

In this implementation, the size of the substrate is set to be greater than the size of the backlight module, and the support ring is fastened to the substrate, so that the support ring and the encapsulation cover can completely encapsulate the color conversion module and the backlight module. This expands a range in which the cover assembly completely encapsulates each functional structure in the display panel. In this way, encapsulation efficiency and encapsulation effect of the encapsulation module are further improved, and working performance of the display panel is improved.

In a possible implementation, a material of the support ring includes any one of a glass slurry, magnesium oxide, calcium oxide, barium oxide, lithium oxide, sodium oxide, potassium oxide, zinc oxide, aluminum oxide, tin oxide, iron oxide, copper oxide, tungsten oxide, borosilicate lead glass, tin phosphate glass, and vanadate glass.

In a possible implementation, the first encapsulation layer is attached to the color conversion module.

In this implementation, the first encapsulation layer is disposed to be partially attached to the color conversion module, so that the buffer layer and an edge of the buffer layer can be completely encapsulated, to prevent impurities such as water, oxygen, and dust from eroding the quantum dot unit from the edge of the buffer layer. Therefore, effect of encapsulating the quantum dot unit by the first encapsulation layer can be improved, and effect of encapsulating the display panel can be further improved.

In a possible implementation, the first encapsulation layer is attached to the backlight module.

In this implementation, the first encapsulation layer is disposed to extend to be attached to the backlight module, to expand a coverage size and an encapsulation range of the first encapsulation layer, so that effect of encapsulating the display panel by the first encapsulation layer can be further improved.

In a possible implementation, the first encapsulation layer is attached to the substrate.

In this implementation, the first encapsulation layer is disposed to extend to be attached to the substrate, to expand a coverage size and an encapsulation range of the first encapsulation layer, so that effect of encapsulating the display panel by the first encapsulation layer can be further improved.

In a possible implementation, in a plane direction of the display panel, there is a first distance between an outer edge of the color conversion module and an outer edge of the substrate, there is a second distance between an outer edge of the backlight module and the outer edge of the substrate, the first distance is greater than the second distance, and the encapsulation module is in a stepped shape.

In this implementation, the first distance is set to be greater than the second distance, and the encapsulation module is in a stepped shape, so that a distance at which edge water vapor diffuses into the display panel can be increased, to achieve effect of suppressing water and oxygen diffusion. This further reduces a water vapor transmission rate of the display panel, and improves effect of encapsulating the display panel by the encapsulation module. The encapsulation module is in a stepped shape, so that a bonding size between film layers of the encapsulation module is increased, and adhesion effect between the film layers is improved. This reduces a risk of peeling off the film layers in a cutting process, and this improves edge encapsulation effect of the encapsulation module.

In a possible implementation, the encapsulation module is in a stepped shape on a periphery of the color conversion module.

In a possible implementation, the encapsulation module is in a stepped shape on a periphery of the backlight module.

In a possible implementation, in a plane direction of the display panel, a distance between an outer edge of the encapsulation module and an outer edge of the substrate ranges from 50 µm to 150 µm.

In this implementation, the distance between the outer edge of the encapsulation module and the outer edge of the substrate is set to ranging from 50 µm to 150 µm, to avoid damage to a film layer of the encapsulation module caused by chipping effect in a process of cutting the display panel, for example, causing peeling between film layers, or affecting edge encapsulation effect of the encapsulation module. In other words, the distance between the outer edge of the encapsulation module and the outer edge of the substrate is set to ranging from 50 µm to 150 µm, so that a cutting lane can be bypassed, edge encapsulation effect of the encapsulation module can be ensured, and working performance of the display panel can be further improved.

In a possible implementation, a distance between an outer edge of the encapsulation module and an outer edge of the backlight module ranges from 50 µm to 100 µm.

In this implementation, the distance between the outer edge of the encapsulation module and the outer edge of the backlight module is set to ranging from 50 µm to 100 µm, so that a side wall of the driver backplane of the backlight module can be completely encapsulated, to form protection effect on the side wall of the driver backplane, and improve edge encapsulation effect of the encapsulation module.

In a possible implementation, a distance between an outer edge of the first encapsulation layer and an outer edge of the backlight module is greater than 50 µm.

In this implementation, the distance between the outer edge of the first encapsulation layer and the outer edge of the backlight module is set to be greater than 50 µm, so that it can be ensured that the second encapsulation layer well covers an edge of the first encapsulation layer, to further improve edge encapsulation effect of the encapsulation module.

In a possible implementation, a material of the quantum dot unit includes at least one of cadmium selenide, cadmium sulfide, zinc selenide, zinc sulfide, indium phosphide, cadmium telluride, zinc telluride, and silver indium gallium sulfide.

In this implementation, thermal stability of the quantum dot can be improved by setting the material of the quantum dot unit to the alloy quantum dot, the quantum dot doped with an alloy material, or a solid ligand modified quantum dot. In this way, working performance and working effect of the quantum dot are improved. A core-shell structure design can improve optical stability of the quantum dot.

In a possible implementation, the quantum dot unit is any one of a quantum dot solution, a quantum dot adhesive, a quantum dot nano-microporous filling structure, or a porous gallium nitride filling structure.

In this implementation, the structure of the quantum dot unit is set to the quantum dot nano-microporous filling structure, so that heat dissipation effect of the quantum dot unit can be improved, working stability and effectiveness of the quantum dot unit can be improved, and a service life of the quantum dot unit can be prolonged. In addition, the structure of the quantum dot unit is set to the quantum dot nano-microporous filling structure, so that an absorption optical path of the quantum dot unit can be increased.

In a possible implementation, the quantum dot unit is prepared through any one of a spin coating process, a drip coating process, an inkjet printing process, a QD-PR lithography process, or a QD electrochemical deposition process.

In a possible implementation, a material of the first encapsulation layer may be any one of aluminum oxide, aluminum nitride, zinc oxide, and zirconia.

In this implementation, materials of the aluminum oxide, the aluminum nitride, the zinc oxide, and the zirconia are characterized by high compactness and transparency, and the material of the first encapsulation layer is set to one of aluminum oxide, aluminum nitride, zinc oxide, and zirconia, so that encapsulation effect of the first encapsulation layer can be ensured, and a water-oxygen blocking capability of the first encapsulation layer is improved. The first encapsulation layer is a transparent thin film, so that the first encapsulation layer can be prevented from affecting light-emitting effect of the color conversion module.

In a possible implementation, the encapsulation module includes at least one blocking plate, the blocking plate is disposed around a periphery of the plurality of quantum dot units, and the first encapsulation layer covers the blocking plate.

In this implementation, the blocking plate is disposed around the periphery of the plurality of quantum dot units, and the first encapsulation layer is disposed to cover the blocking plate, so that a diffusion process of water and oxygen permeation can be increased, to further suppress water and oxygen diffusion, and reduce a water vapor transmission rate of the display panel. In other words, the blocking plate is disposed around a periphery of a display area, so that encapsulation effect of the encapsulation module can be further improved, to ensure working stability and working effect of each functional structure in the display panel.

In a possible implementation, the buffer layer is accommodated in the blocking plate, and a thickness of the buffer layer ranges from 30 nm to 5 µm.

In this implementation, the buffer layer is disposed to be accommodated in the blocking plate, so that the blocking plate can limit the boundary of the buffer layer, to implement anti-overflow effect for the buffer layer. The thickness of the buffer layer is set to ranging from 30 nm to 5 µm, so that the thickness of the buffer layer is increased. This can reduce difficulty in controlling the thickness of the buffer layer in a manufacturing process, and improve preparation effect and quality of the buffer layer. In addition, increasing the thickness of the buffer layer can improve protection effect of the buffer layer on the quantum dot unit, and improve flattening effect of the buffer layer, to facilitate subsequent film layer manufacturing, and further improve encapsulation effect of the encapsulation module.

In a possible implementation, a quantity of the blocking plates is one to six.

In this implementation, the quantity of the blocking plates is set to one to six, so that the quantity of the blocking plates can be adjusted based on an actual design requirement of the display panel, to improve encapsulation effect of the display panel. In this way, the display panel is applicable to more application scenarios.

In a possible implementation, the blocking plate includes a first blocking plate and a second blocking plate, and the first blocking plate is closer to the LED light-emitting unit than the second blocking plate. In a direction in which the substrate and the backlight module are opposite to each other, a height of the first blocking plate is less than a height of the second blocking plate.

In a possible implementation, the color conversion module includes a quantum dot pixel definition layer, a plurality of mutually spaced pixel holes are provided in the quantum dot pixel definition layer, and each quantum dot unit is embedded in one pixel hole.

In this implementation, each quantum dot unit is disposed to be embedded in one pixel hole, so that each quantum dot unit can be separately encapsulated, that is, pixel-level encapsulation of the quantum dot unit is implemented, to further reduce a possibility that the quantum dot unit is eroded and damaged by water and oxygen, and to further improve stability and effectiveness of the quantum dot unit. The pixel holes are disposed to be spaced, so that light crosstalk between adjacent quantum dot units can be prevented, to ensure normal picture display of the display panel.

In a possible implementation, a passivation layer is disposed on an inner wall of each pixel hole, and the passivation layer is configured to prevent charge transfer between the quantum dot pixel definition layer and the quantum dot unit.

In this implementation, the passivation layer is disposed, so that charge transfer between the quantum dot pixel definition layer and the quantum dot unit can be prevented, to further ensure working stability and working effect of the quantum dot unit.

In a possible implementation, the passivation layer is made through an atomic layer deposition process or a sputtering process.

In a possible implementation, a material of the passivation layer is any one of aluminum oxide, aluminum nitride, silicon dioxide, silicon nitride, hafnium oxide, zirconia, silicon carbon nitride, boron nitride, and silicon oxynitride.

In a possible implementation, a thickness of the passivation layer ranges from 5 nm to 50 nm.

In a possible implementation, a transition layer is further disposed between the first encapsulation layer and the second encapsulation layer, and the transition layer is configured to enhance adhesion force between the first encapsulation layer and the second encapsulation layer.

In this implementation, the transition layer is disposed, so that the adhesion force between the first encapsulation layer and the second encapsulation layer can be improved, to further improve effect of encapsulating the display panel by the encapsulation module. The adhesive force between the first encapsulation layer and the second encapsulation layer is enhanced, so that a film layer peeling off in a cutting process of the encapsulation module can be avoided, to improve stability between film layers of the encapsulation module.

In a possible implementation, a thickness of the transition layer ranges from 30 nm to 100 nm, and a material of the transition layer may be SiO₂.

In a possible implementation, the display panel further includes an optical functional module. The optical functional module is located on a side that is of the encapsulation module and that is away from the substrate. The optical functional module is configured to adjust and control a light shape of light emitted by the backlight module.

In this implementation, the optical function module is disposed, so that the light shape of the light emitted by the backlight module can be adjusted and controlled. This enriches picture display effect of the display panel and improves user experience.

In a possible implementation, the optical functional module is either of a distributed bragg reflector and a microlens.

According to a second aspect, this application further provides an electronic device, including a housing and the display panel in any one of the foregoing implementations. The display panel is embedded on the housing, and the housing is configured to support and protect the display panel.

In this application, the electronic device can implement a picture display function by disposing the display panel. The housing is disposed to support and protect the display panel, so that the display panel can work normally.

Because the electronic device in this application uses the display panel in any one of the foregoing implementations, the electronic device in this application has all possible beneficial effects of the display panel in any one of the foregoing implementations.

In a possible implementation, the electronic device may be but is not limited to any one of augmented reality (Augmented Reality, AR) glasses, virtual reality (Virtual Reality, VR) glasses, a near-eye display (Near-Eye Display, NED), a mobile phone, a tablet computer, a television, or a notebook computer.

### BRIEF DESCRIPTION OF DRAWINGS

To describe technical solutions in this application more clearly, the following briefly describes accompanying drawings for describing implementations. Clearly, the accompanying drawings in the following descriptions are merely some implementations of this application, and a person of ordinary skill in the art may still derive other drawings from these accompanying drawings without creative efforts.
FIG. 1 is a diagram of a working scenario of an electronic device according to this application;
FIG. 2 is a diagram of a structure from a perspective of a side of a display panel of an electronic device according to this application;
FIG. 3 is a diagram of a structure from a perspective of a side of the display panel according to the embodiment shown in FIG. 2;
FIG. 4 is a diagram of a cross-sectional structure from a perspective of a side of the display panel in the embodiment shown in FIG. 3;
FIG. 5 is an enlarged diagram of a partial structure of the display panel at a location C in the embodiment shown in FIG. 4;
FIG. 6 is a diagram of a structure from a perspective of a side of the display panel according to an embodiment;
FIG. 7 is a diagram of a structure from a perspective of a side of a quantum dot in a quantum dot unit according to an embodiment;
FIG. 8 is a diagram of a structure from a perspective of a side of a display panel according to an embodiment;
FIG. 9 is a diagram of a structure from a perspective of a side of a display panel according to an embodiment;
FIG. 10 is a diagram of a structure from a perspective of a side of a display panel according to an embodiment;
FIG. 11 is a diagram of a structure from a perspective of a side of a display panel according to an embodiment;
FIG. 12 is a diagram of a structure from a perspective of a side of a display panel according to an embodiment;
FIG. 13 is a diagram of a structure from a perspective of a side of a display panel according to an embodiment;
FIG. 14 is a diagram of a cross-sectional structure of the display panel at a location D-D in the embodiment shown in FIG. 13;
FIG. 15 is a diagram of a structure from a perspective of a side of a display panel according to an embodiment;
FIG. 16 is a diagram of a structure from a perspective of a side of a display panel according to an embodiment;
FIG. 17 is a diagram of a structure from a perspective of a side of a display panel according to an embodiment;
FIG. 18 is a diagram of a structure from a perspective of a side of a display panel according to an embodiment;
FIG. 19 is a diagram of a structure from a perspective of a side of a display panel according to an embodiment;
FIG. 20 is a diagram of a structure from a perspective of a side of a display panel according to an embodiment;
FIG. 21 is a diagram of a structure from a perspective of a side of a display panel according to an embodiment;
FIG. 22 is an enlarged diagram of a partial structure of the display panel at a location E in the embodiment shown in FIG. 21;
FIG. 23 is a diagram of a structure from a perspective of a side of a display panel according to an embodiment;
FIG. 24 is a diagram of a structure from a perspective of a side of a display panel according to an embodiment;
FIG. 25 is a diagram of a structure from a perspective of a side of a display panel according to an embodiment;
FIG. 26 is a diagram of a structure from a perspective of a side of a display panel according to an embodiment;
FIG. 27 is a diagram of a structure from a perspective of a side of a display panel according to an embodiment;
FIG. 28 is a diagram of a structure from a perspective of a side of a display panel according to an embodiment;
FIG. 29 is a schematic flowchart of preparing an LED light-emitting unit according to an embodiment;
FIG. 30 is a diagram of a structure from a perspective of a side of a backlight module prepared in the embodiment shown in FIG. 29;
FIG. 31 is a diagram of a structure from a perspective of a side of the backlight module at a location F-F according to the embodiment shown in FIG. 30;
FIG. 32 is a schematic flowchart of preparing a display panel in this application according to an embodiment; and
FIG. 33 is a diagram of a structure from a perspective of a side of a display panel according to an embodiment.

### DESCRIPTION OF EMBODIMENTS

The following describes the technical solutions in embodiments of this application with reference to the accompanying drawings in embodiments of this application. It is clear that the described embodiments are merely a part of but not all of the implementations of this application. All other embodiments obtained by a person of ordinary skill in the art based on embodiments of this application without creative efforts shall fall within the protection scope of this application.

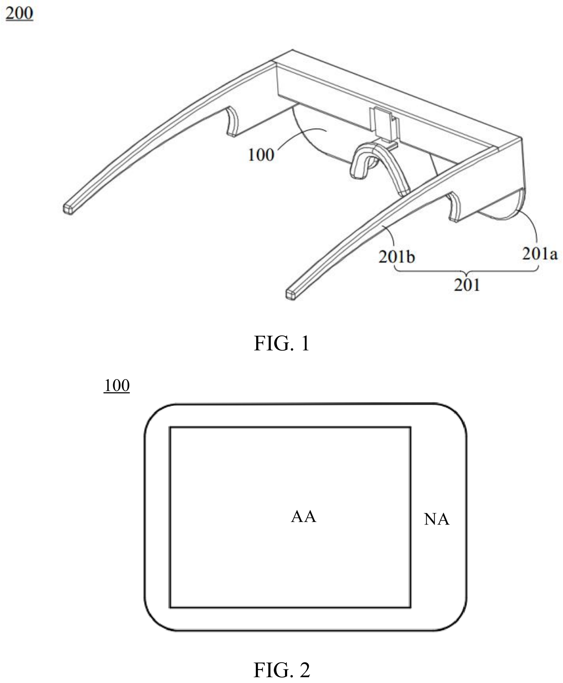

FIG. 1 is a diagram of a working scenario of an electronic device 200 according to this application. As shown in FIG. 1, the electronic device 200 in this application includes a display panel 100 and a housing 201. The display panel 100 is embedded on the housing 201, and is configured to implement a picture display function of the electronic device 200.

The housing 201 is configured to support and fasten the display panel 100, and can protect the display panel 100, so that the display panel 100 can work normally.

For example, the housing 201 can protect and buffer the display panel 100 and another functional structure disposed inside the housing 201 under impact of external force like a drop, a bump, or a collision, to avoid damage to an internal functional structure of the display panel 100 caused by external impact.

The display panel 100 is fixedly disposed on the housing 201, so that a service life and working stability of the display panel 100 can be improved. This improves user experience of the electronic device 200 in this application.

For example, in the implementation shown in FIG. 1, the electronic device 200 is augmented reality (Augmented Reality, AR) glasses. The housing 201 includes a frame 201a and glasses arms 201b. The glasses arm 201b is rotatably connected to the frame 201a. The glasses arm 201b and the frame 201a are configured to fasten the augmented reality glasses to a head of a user.

The display panel 100 is fastened to the frame 201a, and there may be two display panels 100. The two display panels 100 are respectively disposed corresponding to a left eye and a right eye of the user, and are configured to display an image to the user. The two display panels 100 may be transparent displays, so that the user can view visible scene light from an environment, and the visible scene light is mixed with an image displayed on the display panel 100, to achieve effect of augmented reality.

In an embodiment, when the electronic device 200 is virtual reality (Virtual Reality, VR) glasses, the display panel 100 may be a non-transparent display, and the display panel 100 is mounted on a virtual display head-mounted apparatus (namely, the housing 201). As a display apparatus of the virtual reality glasses, the display panel 100 is configured to display a virtual reality image to a user.

In embodiments of this application, an example in which the electronic device 200 is augmented reality glasses is used for description, and the electronic device 200 in this application is not limited to being the augmented reality glasses.

In another embodiment of this application, the electronic device 200 may alternatively be virtual reality glasses, a near-eye display (Near-Eye Display, NED), a mobile phone, a tablet computer, a television, a notebook computer, another intelligent wearable device (for example, a smartwatch or a smart band), or another electronic product having a display function. This is not specifically limited in this application.

In embodiments shown in FIG. 1, an embodiment of the housing 201 and the display panel 100 is used as an example for description. This does not represent a limitation on specific structures and locations of the housing 201 and the display panel 100. For ease of description, in subsequent embodiments of this application, an example in which the electronic device 200 is augmented reality glasses is used for description.

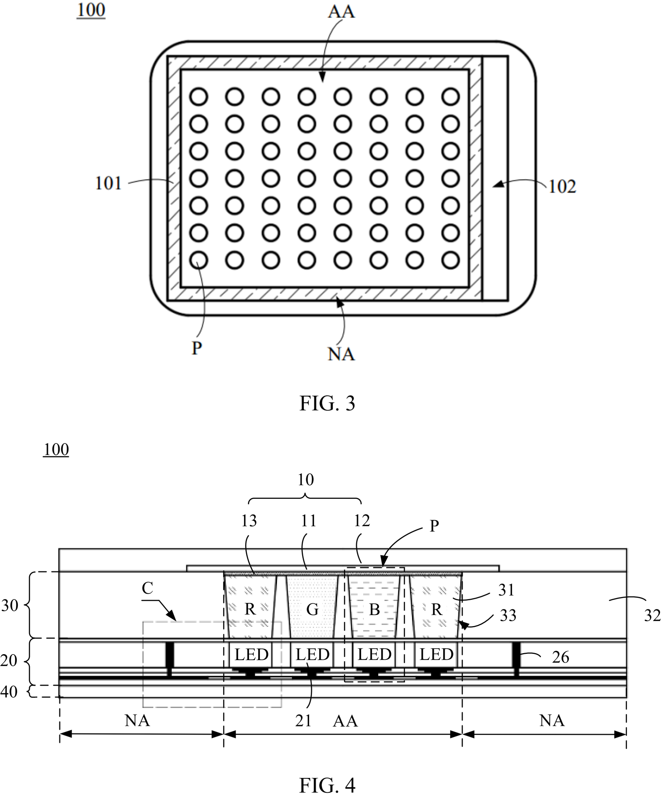

Refer to FIG. 2 and FIG. 3. FIG. 2 is a diagram of a structure from a perspective of a side of the display panel 100 of the electronic device 200 according to this application. FIG. 3 is a diagram of a structure from a perspective of a side of the display panel 100 according to the embodiment shown in FIG. 2. The display panel 100 has a display area AA and an edge area NA. In the embodiment shown in FIG. 2, the edge area NA is continuously disposed around the display area AA.

For example, as shown in FIG. 3, a plurality of pixel units P are disposed in the display area AA, and the pixel unit P is configured to emit light outward, so that the display panel 100 can display a picture on the display area AA. A color of the light emitted by the pixel unit P includes but is not limited to any one of colors such as red, green, blue, and yellow.

In the embodiment shown in FIG. 3, an arrangement manner and a quantity of the pixel units P that may be implemented are described by using an example, but the quantity and the arrangement manner of the pixel units P arranged in the display area AA are not limited thereto. In another embodiment of this application, the arrangement manner and the quantity of pixel units P may be adjusted based on an actual display requirement.

In an embodiment, a plurality of metal cables (not shown in the figure) may be further disposed in the display area AA, and the metal cables are electrically connected to the pixel units P, to conduct the pixel units P and transfer drive signals to the pixel units P. In this way, the display panel 100 can implement different picture display effect. In an embodiment, the metal cables arranged in the display area AA may include a plurality of scanning lines and a plurality of data cables.

In an embodiment, several drive circuits 101 or drive chips (not shown in the figure) may be further disposed in the edge area NA. The several drive circuits 101 are electrically connected to the pixel units P through the metal cables, so that the drive circuits 101 can apply drive signals to the pixel units P through the metal cables, to control the pixel units P to implement different light-emitting effect. The drive circuit 101 includes but is not limited to a scan drive circuit, a data drive circuit, and the like.

In an embodiment, at least one pad area (Pad Area) 102 may be further disposed in the edge area NA, and the pad area 102 is an area in which an electrode is connected to a peripheral drive integrated circuit. A plurality of pads may be arranged in the pad area 102.

In embodiments shown in FIG. 3, an example in which one pad area 102 is disposed in the edge area NA is used for description. In another embodiment of this application, a quantity of pad areas 102 may alternatively be but is not limited to two or three. In addition, arrangement locations of the two or three pad areas 102 may also be adjusted based on an actual design requirement. This is not limited in this application.

In embodiments shown in FIG. 2 and FIG. 3, an embodiment of the display area AA and the edge area NA is described by using an example, and arrangement locations and sizes of the display area AA and the edge area NA are not limited. In another embodiment of this application, the arrangement locations and the sizes of the display area AA and the edge area NA may be adjusted based on an actual design requirement.

For example, in an embodiment, an arrangement location and a size of the edge area NA may be adjusted, to implement effect of narrow-edge display, frameless display, or bezel-less screen display of the display panel 100, so as to implement different display effect of the electronic device 200, and further improve user experience.

FIG. 4 is a diagram of a cross-sectional structure from a perspective of a side of the display panel 100 in the embodiment shown in FIG. 3. In the embodiment shown in FIG. 4, the display panel 100 includes a substrate 40, a backlight module 20, a color conversion module 30, and an encapsulation module 10. The backlight module 20, the color conversion module 30, and the encapsulation module 10 are sequentially stacked on the substrate 40.

As shown in FIG. 4, the substrate 40, the backlight module 20, the color conversion module 30, and the encapsulation module 10 are all laid in the display area AA, and the substrate 40, the backlight module 20, the color conversion module 30, and the encapsulation module 10 separately extend into the edge area NA.

To clearly show the cross-sectional structure of the display panel 100, in the embodiment shown in FIG. 4, four pixel units P are used as an example for description, but a quantity of pixel units P arranged on the display panel 100 is not limited to 4. In other words, the quantity of pixel units P arranged on the display panel 100 may be set based on an actual design requirement.

The substrate 40 is configured to support and fasten each functional structure in the display panel 100, so that each functional structure in the display panel 100 can be stacked on a surface of the substrate 40, and can work normally. A drive circuit in the display panel is usually formed through processing on the substrate, and then is bonded and interconnected to the display module. The substrate 40 may be but is not limited to a Si substrate, a sapphire substrate, a SiC substrate, a GaN substrate, or the like.

The backlight module 20 is configured to provide a light source. In other words, the backlight module 20 can emit light, to provide a light source for the display panel 100 to implement a picture display function.

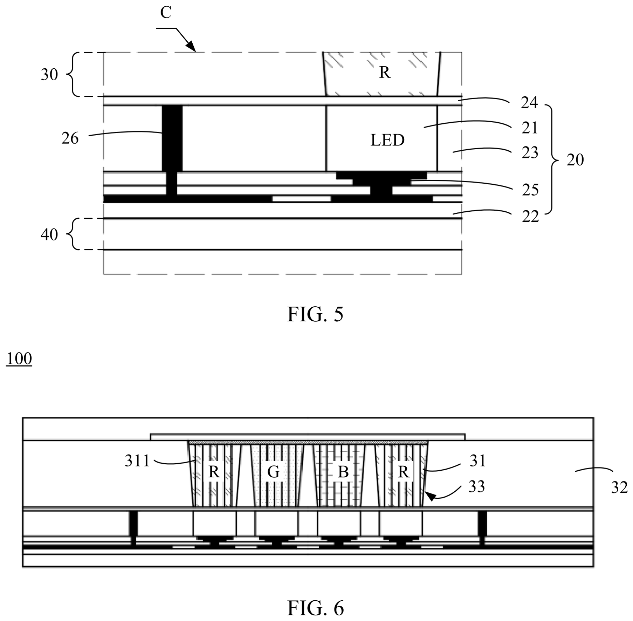

For example, in an embodiment, FIG. 5 is an enlarged diagram of a partial structure of the display panel 100 at a location C in the embodiment shown in FIG. 4. In the embodiment shown in FIG. 5, the backlight module 20 includes a plurality of LED light-emitting units 21, a driver backplane 22, a filling layer 23, and an electrode layer 24 that are stacked. The filling layer 23 is located between the driver backplane 22 and the electrode layer 24. The plurality of LED light-emitting units 21 are spaced from each other and are all embedded in the filling layer 23. The plurality of LED light-emitting units 21 are accommodated in the display area AA, and the filling layer 23 extends into the edge area NA. A size of the backlight module 20 is greater than a size of the first encapsulation layer 11, and the second encapsulation layer 12 is further attached to one or more of the driver backplane 22, the filling layer 23, and the electrode layer 24 in the edge area NA.

A location of the LED light-emitting unit 21 is set corresponding to a location of the pixel unit P in the display area AA. The LED light-emitting unit 21 is constructed as a part of the pixel unit P, and the LED light-emitting unit 21 is configured to provide a light source for the pixel unit P corresponding to the LED light-emitting unit 21.

In the embodiment shown in FIG. 5, a dimension of each LED light-emitting unit 21 ranges from 1 µm to 50 µm, and each LED light-emitting unit 21 may be a micro light-emitting diode (Micro Light-Emitting Diode, Micro-LED). It may be understood that, the dimension of each LED light-emitting unit 21 is set to ranging from 1 µm to 50 µm, so that a quantity of LED light-emitting units 21 that can be arranged in the display area AA can be increased, and an arrangement density of the pixel units P in the display area AA can be increased. Further, picture display luminance, contrast, and the like of the display panel 100 are improved, to improve picture display effect of the display panel 100.

FIG. 5 is described by using a possible implementation of a structural dimension and a structural shape of the LED light-emitting unit 21 as an example, but the shape and the dimension of the LED light-emitting unit 21 are not limited thereto. In another embodiment of this application, the LED light-emitting unit 21 may alternatively be an LED light-emitting unit of another dimension. For example, the LED light-emitting unit 21 may alternatively be but is not limited to a mini-LED whose dimension ranges from 100 µm to 200 µm.

In subsequent descriptions of embodiments, an example in which each LED light-emitting unit 21 is a micro-LED is used for description in this application.

In an embodiment, the filling layer 23 is made of an insulation material, and includes but is not limited to silicon dioxide.

As shown in FIG. 5, the electrode layer 24 covers a surface that is of the filling layer 23 and that is away from the substrate 40, and is attached to a surface that is of each LED light-emitting unit 21 and that is away from the substrate 40, so that the electrode layer 24 can be electrically connected to a first electrode (not shown in the figure) of each LED light-emitting unit 21.

A conductive portion 26 is further disposed between the electrode layer 24 and the driver backplane 22. An end of the conductive portion 26 is electrically connected to the transparent electrode layer 24, and is electrically connected to the driver backplane 22 by passing through the filling layer 23. The conductive portion 26 is located in the edge area NA. The conductive portion 26 is disposed in the edge area NA, so that the conductive portion 26 can be prevented from affecting a light-emitting path and light-emitting effect of each LED light-emitting unit 21. This can improve light-emitting efficiency and light-emitting effect of the backlight module 20.

A second electrode (not shown in the figure) of each LED light-emitting unit 21 is electrically connected to the driver backplane 22 through a bonding layer 25. As shown in FIG. 5, one side that is of the bonding layer 25 and that is away from the driver backplane 22 is electrically connected to the second electrode of each LED light-emitting unit 21, and another opposite side of the bonding layer 25 is electrically connected to the driver backplane 22.

Polarities of the first electrode and the second electrode are opposite.

In the embodiment shown in FIG. 5, the first electrode is a cathode, and the second electrode is an anode. The electrode layer 24 electrically connected to the first electrode may be an indium tin oxide (Indium Tin Oxide, ITO) thin film layer. It may be understood that, the electrode layer 24 is disposed as the indium tin oxide thin film layer, and is a transparent thin film layer, so that the electrode layer 24 conducts each LED light-emitting unit 21 while preventing the electrode layer 24 from blocking light-emitting of the LED light-emitting unit 21.

In another embodiment, the first electrode may be an anode, and the second electrode may be a cathode.

In the embodiment shown in FIG. 5, a possible conduction manner of each LED light-emitting unit 21 is used as an example to describe a functional structure of the backlight module 20 and an arrangement location of each functional structure. However, the embodiment of the backlight module 20 is not limited thereto. Disposal of each functional structure in the backlight module 20 may be adjusted based on an actual design requirement. This is not limited in embodiments of this application.

It may be understood that, in the backlight module 20, each LED light-emitting unit 21 is disposed to be electrically connected to the driver backplane 22, so that the driver backplane 22 can control each LED light-emitting unit 21 to emit light, to implement different light-emitting effect.

For an embodiment, refer to FIG. 5. In the embodiment shown in FIG. 5, the surface that is of the filling layer 23 and that is away from the substrate 40 is flush with the surface that is of the LED light-emitting unit 21 and that is away from the substrate 40, and the filling layer 23 completely covers the edge area NA.

The surface that is of the filling layer 23 and that is away from the substrate 40 is disposed to be flush with the surface that is of the LED light-emitting unit 21 and that is away from the substrate 40, and the filling layer 23 is disposed to completely cover the edge area NA, so that a bonding yield and bonding effect between the LED light-emitting unit 21 and the driver backplane 22 can be improved. In this way, light-emitting efficiency and light-emitting effect of the backlight module 20 are improved, and working performance of the backlight module 20 is ensured.

Still refer to FIG. 4. The color conversion module 30 is configured to convert a wavelength of light emitted by the backlight module 20, and emit the light from the display area AA. Wavelengths of different colors may form different light-emitting colors, to implement full-color display of the display panel 100. In the embodiment shown in FIG. 4, the backlight module 20 is located between the substrate 40 and the color conversion module 30, and all light emitted by the backlight module 20 is emitted to the color conversion module 30, to excite the color conversion module 30 to emit light and convert the wavelength of the light emitted by the backlight module 20.

For example, the color conversion module 30 includes a plurality of quantum dot units 31 and a quantum dot pixel definition layer 32, the plurality of quantum dot units 31 are all embedded in the quantum dot pixel definition layer 32, and a size of the quantum dot pixel definition layer 32 is greater than a size of the first encapsulation layer 11. The second encapsulation layer 12 is further attached to the quantum dot pixel definition layer 32 in the edge area NA.

The plurality of quantum dot units 31 are disposed in a one-to-one correspondence with the plurality of LED light-emitting units 21, that is, each quantum dot unit 31 is disposed at a location of a corresponding LED light-emitting unit 21. The quantum dot unit 31 is configured to convert the wavelength of the light emitted by the LED light-emitting unit 21.

Light of different wavelengths correspondingly implements different light-emitting colors. The quantum dot unit 31 is configured to convert the wavelength of the light emitted by the LED light-emitting unit 21. This may mean that the quantum dot unit 31 is configured to convert a color of the light emitted by the LED light-emitting unit 21.

For example, in an embodiment, when the quantum dot unit 31 converts the wavelength of the light emitted by the LED light-emitting unit 21 into 625 nm to 740 nm, a light-emitting color formed by the quantum dot unit 31 is red.

For example, in an embodiment, when the quantum dot unit 31 converts the wavelength of the light emitted by the LED light-emitting unit 21 into 570 nm to 585 nm, a light-emitting color formed by the quantum dot unit 31 is yellow.

For example, in an embodiment, when the quantum dot unit 31 converts the wavelength of the light emitted by the LED light-emitting unit 21 into 492 nm to 577 nm, a light-emitting color formed by the quantum dot unit 31 is green.

For example, in an embodiment, when the quantum dot unit 31 converts the wavelength of the light emitted by the LED light-emitting unit 21 into 440 nm to 475 nm, a light-emitting color formed by the quantum dot unit 31 is blue.

For the display panel 100 in this application, a group of LED light-emitting units 21 and the quantum dot units 31 whose locations correspond to each other jointly form a pixel unit P.

In the embodiment shown in FIG. 4, the quantum dot pixel definition layer 32 covers the surface that is of the backlight module 20 and that is away from the substrate 40. In other words, in the embodiment shown in FIG. 4, the quantum dot pixel definition layer 32 covers the electrode layer 24.

A plurality of mutually spaced pixel holes 33 are disposed in the quantum dot pixel definition layer 32, one pixel hole 33 is disposed at a location of one corresponding LED light-emitting unit 21, and each quantum dot unit 31 is embedded in one pixel hole 33. As shown in FIG. 4, the plurality of quantum dot units 31 are all embedded in the quantum dot pixel definition layer 32, and each quantum dot unit 31 is disposed at a location of one corresponding LED light-emitting unit 21, so that light emitted by each LED light-emitting unit 21 can be emitted to the quantum dot unit 31 corresponding to the LED light-emitting unit 21, to excite the quantum dot unit 31 to emit light and convert a color of the light emitted by the LED light-emitting unit 21.

It may be understood that the quantum dot pixel definition layer 32 is disposed on the side that is of the backlight module 20 and that is away from the substrate 40, and each quantum dot unit 31 is disposed and embedded in the pixel hole 33, so that each quantum dot unit 31 is located on a light-emitting path of the backlight module 20. In this way, light emitted by each LED light-emitting unit 21 can be emitted to the quantum dot unit 31 corresponding to the LED light-emitting unit 21.

The pixel holes 33 are spaced, so that light crosstalk between adjacent quantum dot units 31 can be prevented, to ensure normal picture display of the display panel 100. Each quantum dot unit 31 is disposed to be embedded in one pixel hole 33, so that each quantum dot unit 31 can be separately encapsulated, that is, pixel-level encapsulation of the quantum dot unit 31 is implemented, to reduce a possibility that the quantum dot unit 31 is eroded and damaged by water and oxygen, and to further improve stability and effectiveness of the quantum dot unit 31.

In the embodiment shown in FIG. 4, colors of light emitted by the plurality of LED light-emitting units 21 are the same, and the light emitted by each LED light-emitting unit 21 may be blue light or UV light. A color of the quantum dot unit 31 may be but is not limited to three primary colors: red (R), green (G), and blue (B), to correspondingly convert blue light or ultraviolet light emitted by the LED light-emitting unit 21 into the three primary colors: red light (R), green light (G), and blue light (B), to implement full-color display of the display panel 100.

In another embodiment of this application, the color of the light emitted by the LED light-emitting unit 21 may alternatively be another color, and is not limited to blue. In other words, the light emitted by the LED light-emitting unit 21 only needs to be capable of excitation of the quantum dot unit 31 to emit light and convert the color.

The color of the quantum dot unit 31 is not limited to the three primary colors: red, green, and blue. In another embodiment of this application, the color of the quantum dot unit 31 may alternatively be a color like yellow or white, to meet different display requirements of the display panel 100, further enrich full-color display effect of the display panel 100, and improve viewing experience of the user.

In an embodiment, as shown in FIG. 4, a projection of each LED light-emitting unit 21 on the substrate 40 is accommodated in a projection of the quantum dot unit 31 corresponding to the LED light-emitting unit 21 on the substrate 40.

The projection of each LED light-emitting unit 21 is set to be accommodated in the projection of the quantum dot unit 31 corresponding to the LED light-emitting unit 21, so that the light emitted by each LED light-emitting unit 21 can be completely emitted to the quantum dot unit 31 for light conversion. In this way, light conversion efficiency of the LED light-emitting unit 21 can be improved, and power consumption of the backlight module 20 can be reduced.

In an embodiment, a material of the quantum dot unit 31 includes but is not limited to a core-shell structure formed by at least one of cadmium selenide (CdSe), cadmium sulfide (CdS), zinc selenide (ZnSe), zinc sulfide (ZnS), indium phosphide (InP), cadmium telluride (CdTe), zinc telluride (ZnTe), and silver indium gallium sulfide (AgInGaS).

Light stability of a quantum dot can be improved by setting a material of the quantum dot unit 31 as a core-shell structure.

In an embodiment, the material of the quantum dot unit 31 includes but is not limited to at least one core-shell quantum dot in CdSe/CdS, CdSe/ZnSe, CdS/ZnS, InP/ZnSe, InP/ZnSe/ZnS, ZnSe/ZnS, CdSe/ZnSe/ZnS, CdSe/CdS/ZnS and InP/GaP.

In an embodiment, the material of the quantum dot unit 31 may be but is not limited to doped Mn and Cu quantum dots.

In an embodiment, the material of the quantum dot unit 31 may be but is not limited to at least one alloy quantum dot in ZnCdSe/ZnSe, CdSeS, ZnCdS, ZnCdSe/ZnS and AgInGaS/ZnS. It may be understood that, in this embodiment, thermal stability of the quantum dot can be improved by setting the material of the quantum dot unit 31 to the alloy quantum dot, the doped quantum dot, or a solid ligand modified quantum dot. In this way, working performance and working effect of the quantum dot are improved.

In an embodiment, FIG. 6 is a diagram of a structure from a perspective of a side of the display panel 100 according to an embodiment. In the embodiment shown in FIG. 6, the quantum dot unit 31 may be but is not limited to a quantum dot nano-microporous filling structure 311, for example, anodic aluminum oxide (Anodic Aluminum Oxide, AAO).

In another embodiment of this application, a quantum dot material corresponding to the quantum dot unit 31 may alternatively be any one of a quantum dot solution filling structure, a quantum dot adhesive filling structure, or a quantum dot porous gallium nitride filling structure.

The structure of the quantum dot unit 31 is set to the quantum dot nano-microporous filling structure, so that heat dissipation effect of the quantum dot unit 31 can be improved, working stability and effectiveness of the quantum dot unit 31 can be improved, and a service life of the quantum dot unit 31 can be prolonged.

In addition, the structure of the quantum dot unit 31 is set to the quantum dot nano-microporous filling structure, so that an absorption optical path of the quantum dot unit 31 can be increased.

In an embodiment, the quantum dot unit 31 is prepared through any one of a spin coating process, a drip coating process, an inkjet printing process, a QD-PR lithography process, or a QD electrochemical deposition process.

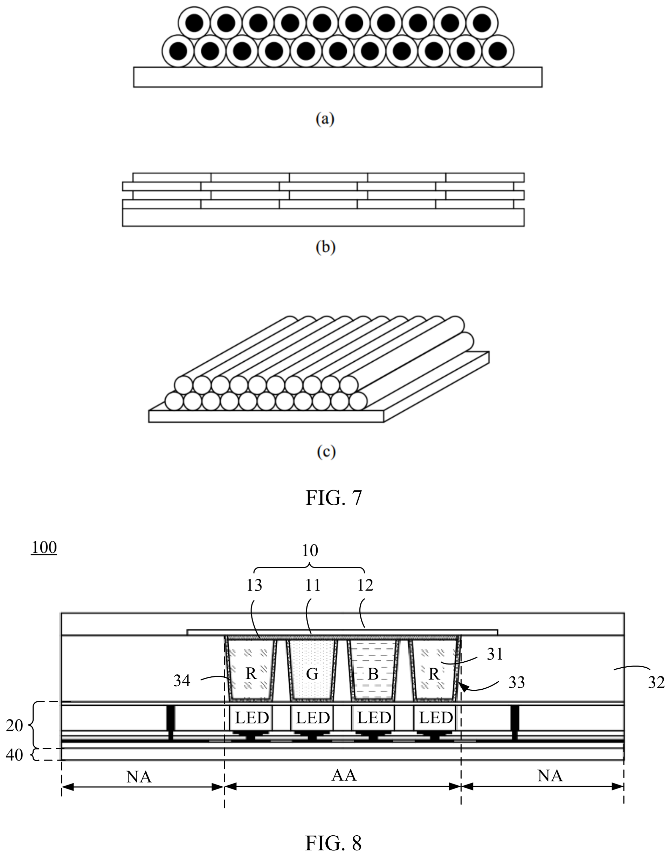

In an embodiment, FIG. 7 is a diagram of a structure from a perspective of a side of a quantum dot in the quantum dot unit 31 according to an embodiment. In the embodiment shown in FIG. 7, a structure of the quantum dot in the quantum dot unit 31 may be any structure of a three-dimensional quantum dot (refer to (a) in FIG. 7), a two-dimensional quantum slice (refer to (b) in FIG. 7), and a one-dimensional quantum rod (refer to (c) in FIG. 7).

In an embodiment, a material of the quantum dot pixel definition layer 32 includes but is not limited to at least one of aluminum (Al), silver (Ag), platinum (Pt), gold (Au), copper (Cu), titanium (Ti), nickel (Ni), and chromium (Cr), and a metal filling structure with strong heat dissipation helps avoid a quantum dot high-temperature failure problem caused by a high junction temperature of the LED light-emitting unit 21.

The quantum dot pixel definition layer 32 is set to be made of a metal material with high reflectivity and high thermal conductivity, so that sidewall light reflectivity of the quantum dot unit 31 can be improved, and an operating temperature of the quantum dot unit 31 can be reduced. This improves light-emitting efficiency and light-emitting effect of the backlight module 20. Light crosstalk between adjacent quantum dot units 31 is further reduced, and an optical angle is reduced.

In an embodiment, a material of the quantum dot pixel definition layer 32 may absorb light. For example, the material of the quantum dot pixel definition layer 32 may be a black matrix, so that light emitted by the quantum dot unit 31 to a side wall of the pixel hole 33 can be absorbed. This avoids light crosstalk between adjacent quantum dot units 31 and affects picture display effect of the display panel 100.

In an embodiment, FIG. 8 is a diagram of a structure from a perspective of a side of the display panel 100 according to an embodiment. As shown in FIG. 8, a passivation layer 34 is disposed on an inner wall of each pixel hole 33, and the passivation layer 34 is configured to prevent charge transfer between the quantum dot pixel definition layer 32 and the quantum dot unit 31.

For example, in the embodiment shown in FIG. 8, a wall surface that is of the quantum dot pixel definition layer 32 and that is exposed at each pixel hole 33 is constructed as a side wall of each pixel hole 33. The quantum dot pixel definition layer 32 covers a surface that is of the electrode layer 24 and that is away from the substrate 40, and a surface that is of the electrode layer 24 and that is exposed from each pixel hole 33 is constructed as a bottom wall of each pixel hole 33.

The passivation layer 34 covers the side wall and the bottom wall of the pixel hole 33, to separate the quantum dot unit 31 from the quantum dot pixel definition layer 32, and separate the quantum dot unit 31 from the electrode layer 24.

The passivation layer 34 is disposed to cover the side wall of each pixel hole 33, to separate the quantum dot pixel definition layer 32 and the quantum dot unit 31 that are made of a metal material. This can prevent charge transfer between the quantum dot pixel definition layer 32 and the quantum dot unit 31 caused by the Schottky barrier. The passivation layer 34 is disposed to cover the bottom wall of each pixel hole 33, to separate each quantum dot unit 31 from the electrode layer 24, so that charge transfer between the electrode layer 24 and the quantum dot unit 31 can be prevented. This affects stability and effectiveness of the quantum dot unit 31.

In an embodiment, refer to FIG. 8. In the embodiment shown in FIG. 8, the passivation layer 34 disposed on the inner wall of each pixel hole 33 is integrally formed. For example, the passivation layer 34 covering the side wall of each pixel hole 33 and the passivation layer 34 covering the bottom wall of the pixel hole 33 are constructed as a whole.

It may be understood that, the passivation layer 34 disposed on the inner wall of each pixel hole 33 is integrally formed, so that independent encapsulation effect can be formed on a side surface of the quantum dot unit 31 located in each pixel hole 33. This prevents the quantum dot unit 31 from being eroded by water, oxygen, water vapor, dust, and the like, to further ensure working stability and working effect of the quantum dot unit 31.

In an embodiment, the passivation layer 34 is made through an atomic layer deposition process, a chemical vapor deposition (CVD) process, or a sputtering process.

In an embodiment, a material of the passivation layer 34 may be any one of aluminum oxide (Al₂O₃), aluminum nitride (AlN), silicon dioxide (SiO₂), silicon nitride (SiNx), hafnium oxide (HfO₂), zirconia (ZrO₂), silicon carbon nitride (SiCN), boron nitride (BN), and silicon oxynitride (SiON).

In an embodiment, a thickness of the passivation layer 34 ranges from 5 nm to 50 nm.

Refer to FIG. 8. The encapsulation module 10 is configured to encapsulation each functional structure in the display panel 100, to prevent water and oxygen from eroding the display panel 100. As shown in FIG. 8, the encapsulation module 10 includes a buffer layer 13 and an encapsulation layer that are stacked. The encapsulation layer covers the color conversion module 30, the buffer layer 13 is located between the encapsulation layer and the color conversion module 30, a size of the buffer layer 13 is greater than a size of a plurality of quantum dot units 31, and the buffer layer 13 is configured to protect the plurality of quantum dot units 31.

In the embodiment shown in FIG. 8, the encapsulation layer includes a first encapsulation layer 11, the buffer layer 13 is located between the color conversion module 30 and the first encapsulation layer 11, and the size of the buffer layer 13 is greater than a sum of sizes of the plurality of quantum dot units 31. In addition, in the embodiment shown in FIG. 8, the buffer layer 13 is attached to each quantum dot unit 31.

That the size of the buffer layer 13 is greater than the sizes of the plurality of quantum dot units 31 means that the size of the buffer layer 13 is greater than a sum of the sizes of all the quantum dot units 31 located in the display area AA. It may also be understood that the buffer layer 13 covers the display area AA.

The buffer layer 13 is configured to separate the first encapsulation layer 11 from the quantum dot unit 31 to protect the quantum dot unit 31. A size of the first encapsulation layer 11 is greater than the size of the buffer layer 13. An edge that is of the first encapsulation layer 11 and that exceeds the buffer layer 13 is attached to the color conversion module 30. In other words, the first encapsulation layer 11 covers the buffer layer 13 and partially covers the edge area NA, and the first encapsulation layer 11 is configured to encapsulation the display panel 100 to prevent water and oxygen erosion.

For example, in the embodiment shown in FIG. 8, the buffer layer 13 covers the display area AA, and the buffer layer 13 is attached to a surface that is of each quantum dot unit 31 and that is away from the substrate 40, to protect the quantum dot unit 31. This avoids a case in which a chemical reaction occurs between a metal-organic precursor corresponding to the first encapsulation layer 11 and the quantum dot material when the first encapsulation layer 11 is subsequently prepared, causing surface damage and ligand detachment of the quantum dot material, reducing light-emitting efficiency and light-emitting effect of the quantum dot unit 31, and reducing stability and effectiveness of the quantum dot unit 31.

In an embodiment, a material of the buffer layer 13 may be but is not limited to any one of a polymer material like polymethylmethacrylate (PMMA), epoxy resin, polyethylene terephthalate (PET), polyethylene naphthalate (PEN), PAVC, poly-p-xylylene (PPX), PCPX, polyimide (transparent PI), polystyrene (PS), polydimethylsiloxane (silicon-based PDMS), or amorphous fluoropolymer resin (fluoro-based CYTOP).

In an embodiment, when the material of the buffer layer 13 is a polymer film layer, any process method in spin coating, inkjet printing, thermal chemical vapor deposition polymerization for film formation, molecular layer deposition (Molecular Layer Deposition, MLD), flash evaporation, photolithography, and UV curing may be used for preparation, but this is not limited.

In an embodiment, a material of the buffer layer 13 may be but is not limited to any one of a dichlorodi-p-xylylene film (Parylene C), a fluorinated di-p-xylylene film (Parylene-AF4 organic film), an organic or inorganic film layer such as a lithium fluoride film (LiF), a titanium dioxide film (TiO₂), a silicon dioxide film (SiO₂), or a hafnium dioxide film (HfO₂).

In an embodiment, when the material of the buffer layer 13 is an organic or inorganic film layer, the buffer layer 13 may use process methods for preparation such as molecular layer deposition, flash evaporation, evaporation, or chemical vapor deposition (Chemical Vapor Deposition, CVD), but the process methods are not limited.

In an embodiment, a thickness of the buffer layer 13 ranges from 30 nm to 5 µm.

In an embodiment, refer to FIG. 8. In the embodiment shown in FIG. 8, the buffer layer 13 defines a boundary by using the quantum dot pixel definition layer 32. The boundary of the buffer layer 13 is limited by using the quantum dot pixel definition layer 32, to implement anti-overflow effect on the buffer layer 13, so that molding effect of the buffer layer 13 can be improved, and protection effect of the buffer layer 13 on the quantum dot unit 31 can be ensured.

It may be understood that, the buffer layer 13 is disposed on the surface that is of the quantum dot unit 31 and that is away from the substrate 40, and the buffer layer 13 is disposed to cover the display area AA, so that preliminary encapsulation effect of each quantum dot unit 31 can be implemented, and encapsulation effect of each quantum dot unit 31 can be further improved.

The buffer layer 13 is disposed between the color conversion module 30 and the first encapsulation layer 11, so that flattening effect can be implemented on a surface that is of each quantum dot unit 31 and that is away from the substrate 40. This facilitates subsequent preparation of another film layer, and improves preparation effect and quality of the another film layer.

Further, the first encapsulation layer 11 is located on a side that is of the buffer layer 13 and that is away from the substrate 40, the first encapsulation layer 11 completely covers the buffer layer 13, and a part of the first encapsulation layer 11 extends into the edge area NA. The first encapsulation layer 11 is attached to one or more of the color conversion module 30, the backlight module 20, and the substrate 40 in the edge area NA.

In the embodiment shown in FIG. 8, the filling layer 23 in the backlight module 20 completely covers the edge area NA, and the quantum dot pixel definition layer 32 in the color conversion module 30 completely covers the filling layer 23. In other words, the quantum dot pixel definition layer 32 extending into the edge area NA completely covers the edge area NA, to form a surface that is of the quantum dot pixel definition layer 32 and that is away from the substrate 40 as a flat surface.

The first encapsulation layer 11 is attached to a surface that is of the buffer layer 13 and that is away from the substrate 40 in the display area AA, and the first encapsulation layer 11 is attached to the surface that is of the quantum dot pixel definition layer 32 and that is away from the substrate 40 in the edge area NA.

It may be understood that, in the embodiment shown in FIG. 8, the first encapsulation layer 11 is disposed to cover the buffer layer 13 and partially extend into the edge area NA, so that a function of encapsulating the display panel 100 by the encapsulation module 10 can be implemented, to prevent water, oxygen, water vapor, dust, or another impurity from eroding each functional structure in the display panel 100. The first encapsulation layer 11 is disposed to cover the buffer layer 13, so that a water vapor transmission rate (Water Vapor Transmission Rate, WVTR) of the display panel 100 can be less than 5×10⁻⁶ g/m²/day.

The quantum dot unit 31 is protected by the buffer layer 13, and the display panel 100 is encapsulated by the first encapsulation layer 11 to prevent the quantum dot unit 31 and another functional structure in the display panel 100 from being eroded by water and oxygen, so that stability and effectiveness of the quantum dot unit 31 can be ensured, picture display effect of the display panel 100 is improved, and user experience is further improved.

In an embodiment, a material of the first encapsulation layer 11 may be but is not limited to any one of aluminum oxide (Al₂O₃), aluminum nitride (AlN), zinc oxide (ZnO), and zirconia (ZrO₂).

Film layers made of aluminum oxide, aluminum nitride, zinc oxide, and zirconia are characterized by high compactness and transparency, and the material of the first encapsulation layer 11 is set to one of aluminum oxide, aluminum nitride, zinc oxide, and zirconia, so that encapsulation effect of the first encapsulation layer 11 can be ensured, and a water-oxygen blocking capability of the first encapsulation layer 11 is improved.

The first encapsulation layer 11 is a transparent thin film, so that the first encapsulation layer 11 can be prevented from affecting light-emitting effect of the color conversion module 30, to further improve picture display luminance and display contrast of the display panel 100.

In an embodiment, the first encapsulation layer 11 is prepared through an atomic layer deposition process or a sputtering process.

The first encapsulation layer 11 is prepared through an atomic layer deposition process or a sputtering process, so that structural density of the first encapsulation layer 11 can be improved, and encapsulation effect of the first encapsulation layer 11 can be improved. This improves working stability and working effect of the quantum dot unit 31, to improve picture display effect and display stability of the display panel 100.

In an embodiment, a thickness of the first encapsulation layer 11 ranges from 20 nm to 200 nm.

In an embodiment, refer to FIG. 8. As shown in FIG. 8, the encapsulation module 10 further includes a second encapsulation layer 12. The second encapsulation layer 12 is attached to a side that is of the first encapsulation layer 11 and that is away from the buffer layer 13. A size of the second encapsulation layer 12 is greater than the size of the first encapsulation layer 11, a size of the substrate 40 is greater than a size of the color conversion module 30, and an edge that is of the second encapsulation layer 12 and that exceeds the first encapsulation layer 11 is attached to the substrate 40.

In other words, the second encapsulation layer 12 is at least partially attached to the substrate 40 in the edge area NA, to encapsulation the display panel 100. In other words, a projection of the first encapsulation layer 11 on the second encapsulation layer 12 is accommodated in the second encapsulation layer 12.

For example, in the embodiment shown in FIG. 8, in the display area AA, the second encapsulation layer 12 is attached to a surface that is of the first encapsulation layer 11 and that is away from the substrate 40. In the edge area NA, the second encapsulation layer 12 is attached to a surface that is of the first encapsulation layer 11 and that is located in the edge area NA and that is away from the substrate 40, and is attached to a surface that is of the quantum dot pixel definition layer 32 and that is away from the substrate 40. The second encapsulation layer 12 completely covers the edge area NA.

The second encapsulation layer 12 is disposed on the side that is of the first encapsulation layer 11 and that is away from the buffer layer 13, so that the display panel 100 can be further encapsulated, to further improve effect of encapsulating the display panel 100 by the encapsulation module 10.

The projection of the first encapsulation layer 11 on the second encapsulation layer 12 is accommodated in the second encapsulation layer 12, so that an edge side of the first encapsulation layer 11 can be encapsulated, impurities such as water, oxygen, and dust in an external environment are prevented from entering the display panel 100 from an edge of the first encapsulation layer 11.

The second encapsulation layer 12 is disposed to be partially attached to the quantum dot pixel definition layer 32, so that the second encapsulation layer 12 can implement encapsulation effect on the quantum dot pixel definition layer 32 and the first encapsulation layer 11, and edge encapsulation effect of the display panel 100 is improved. A possibility of water and oxygen permeation on the edge side of the first encapsulation layer 11 is excluded.

In an embodiment, the second encapsulation layer 12 may be manufactured in any one of a chemical vapor deposition process and a magnetron sputtering process, but this is not limited.

In an embodiment, a material of the second encapsulation layer 12 is silicon nitride (SiNx).

A film layer made of silicon nitride material has good compactness. The material of the second encapsulation layer 12 is set to silicon nitride, so that encapsulation effect of the second encapsulation layer 12 can be improved, and encapsulation effect of the encapsulation module 10 on the display panel 100 can be further improved.

In an embodiment, a thickness of the second encapsulation layer 12 ranges from 200 nm to 4 µm.

In an embodiment, the encapsulation module 10 may include the buffer layer 13 and the second encapsulation layer 12. The second encapsulation layer 12 may be directly attached to a surface of the buffer layer 13. This can also achieve effect of encapsulating the display panel 100 to block water and oxygen erosion. For the display panel 100 in this application, the encapsulation module 10 includes the buffer layer 13 and the encapsulation layer. The encapsulation layer may include a first encapsulation layer 11 or a second encapsulation layer 12. The first encapsulation layer 11 and the second encapsulation layer 12 separately cooperate with the buffer layer 13, to form reliable encapsulation effect for the encapsulation module 10.

In an embodiment, the encapsulation layer may alternatively include both the first encapsulation layer 11 and the second encapsulation layer 12. The first encapsulation layer 11 is disposed between the second encapsulation layer 12 and the buffer layer 13, so that encapsulation effect of the encapsulation module 10 can be further improved.

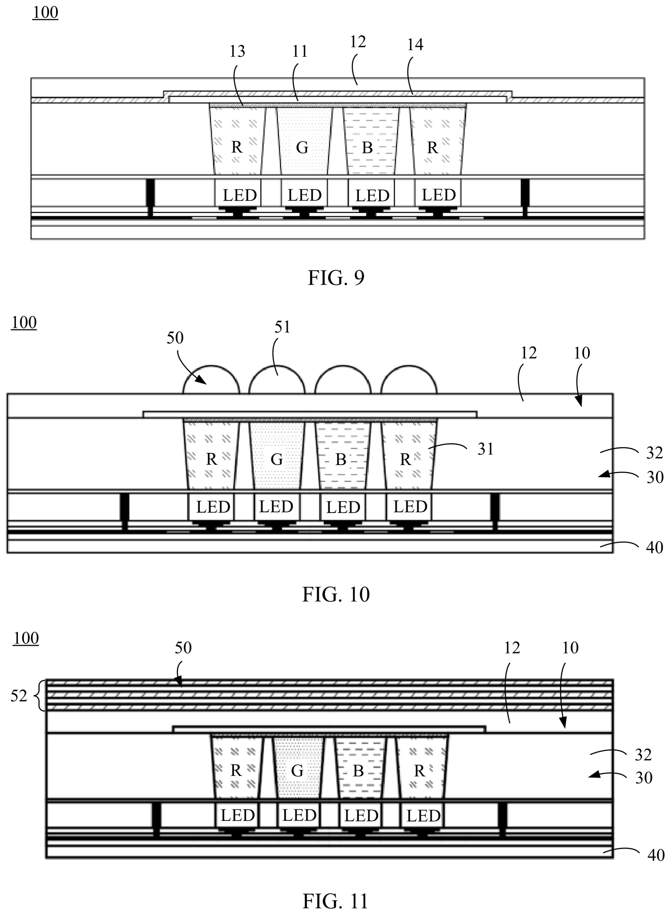

In an embodiment, FIG. 9 is a diagram of a structure from a perspective of a side of the display panel 100 according to an embodiment. The encapsulation module 10 further includes a transition layer 14, and the transition layer 14 is configured to enhance adhesion between the first encapsulation layer 11 and the second encapsulation layer 12. For example, in the embodiment shown in FIG. 9, the transition layer 14 is located between the first encapsulation layer 11 and the second encapsulation layer 12, and the transition layer 14 completely covers the display area AA and the edge area NA.

The transition layer 14 is disposed, so that adhesion between the first encapsulation layer 11 and the second encapsulation layer 12 can be improved, and an undesirable phenomenon like peeling off of the first encapsulation layer 11 and the second encapsulation layer 12 in a process of cutting the display panel 100 is avoided. In other words, the transition layer 14 is disposed between the first encapsulation layer 11 and the second encapsulation layer 12, so that stability of the encapsulation module 10 can be improved, and effect of encapsulating the display panel 100 by the encapsulation module 10 can be improved.

In the embodiment shown in FIG. 9, an example in which the transition layer 14 completely covers the display area AA and the edge area NA is used for description. However, the embodiment of the transition layer 14 is not limited thereto. In another embodiment of this application, for example, the transition layer 14 may completely cover the display area AA, and partially cover the edge area NA. Alternatively, the transition layer 14 may partially cover the display area AA. A size or a location of the transition layer 14 covering the display area AA or the edge area NA is not limited in this application. Both the size and the location of the transition layer 14 may be limited based on an actual design requirement.

In an embodiment, a thickness of the transition layer 14 ranges from 30 nm to 100 nm.

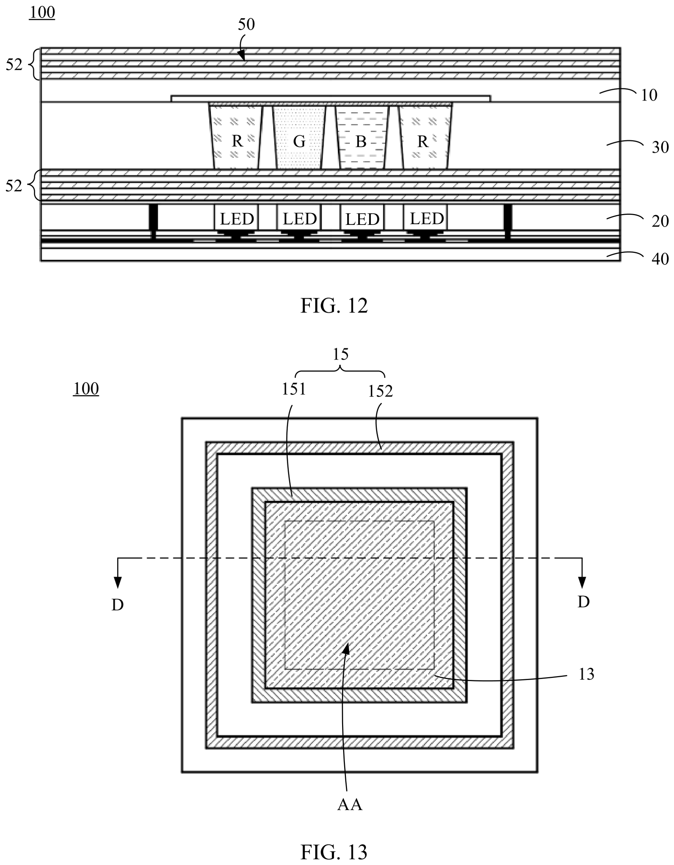

In an embodiment, refer to FIG. 10 to FIG. 12. FIG. 10 is a diagram of a structure from a perspective of a side of the display panel 100 in an embodiment. FIG. 11 is a diagram of a structure from a perspective of a side of the display panel 100 in an embodiment. FIG. 12 is a diagram of a structure from a perspective of a side of the display panel 100 in an embodiment. The display panel 100 further includes an optical functional module 50. The optical functional module 50 is located on a side that is of the encapsulation module 10 and that is away from the substrate 40. The optical functional module 50 is configured to adjust and control a light shape of light emitted by the backlight module 20 or the color conversion module 30.

For example, in the embodiment shown in FIG. 10, the optical functional module 50 includes a plurality of micro lenses (Micro Lenses) 51, and the plurality of micro lenses (Micro Lenses) 51 may be disposed on the side that is of the encapsulation module 10 and that is away from the substrate 40. In addition, each microlens 51 is disposed at a location corresponding to one quantum dot unit 31. The microlens 51 is configured to adjust a light shape of light emitted by the color conversion module 30 to the outside, to implement different light-emitting effect.

In the embodiment shown in FIG. 11, the optical functional module 50 includes a distributed bragg reflector (Distributed Bragg Reflector, DBR) 52. The distributed bragg reflector 52 may be but is not limited to being disposed on the side that is of the encapsulation module 10 and that is away from the substrate 40, and the distributed bragg reflector 52 completely covers the display area AA.

In FIG. 11, an embodiment of the distributed bragg reflector 52 is used as an example for description, but an arrangement location of distributed bragg reflector 52 and an arrangement quantity of distributed bragg reflectors 52 are not limited thereto. Both the arrangement location of distributed bragg reflector 52 and the arrangement quantity of distributed bragg reflectors 52 may be adjusted based on an actual design requirement and a display requirement of the display panel 100. A resonant cavity (resonant cavity) is formed by using the DBR film layer and by reflecting metal by using a bonding layer (FIG. 11), or a resonant cavity is formed by constructing a dual-DBR film layer structure (FIG. 12), so that the resonant cavity can be constructed for target light of the quantum dot unit 31, to reduce an optical angle, and optimize light-emitting shape effect.

It may be understood that the optical functional modules 50 of different structures are disposed, so that adjustment and control of different light-emitting shapes can be implemented. This enriches picture display effect of the display panel 100 and improves user experience.

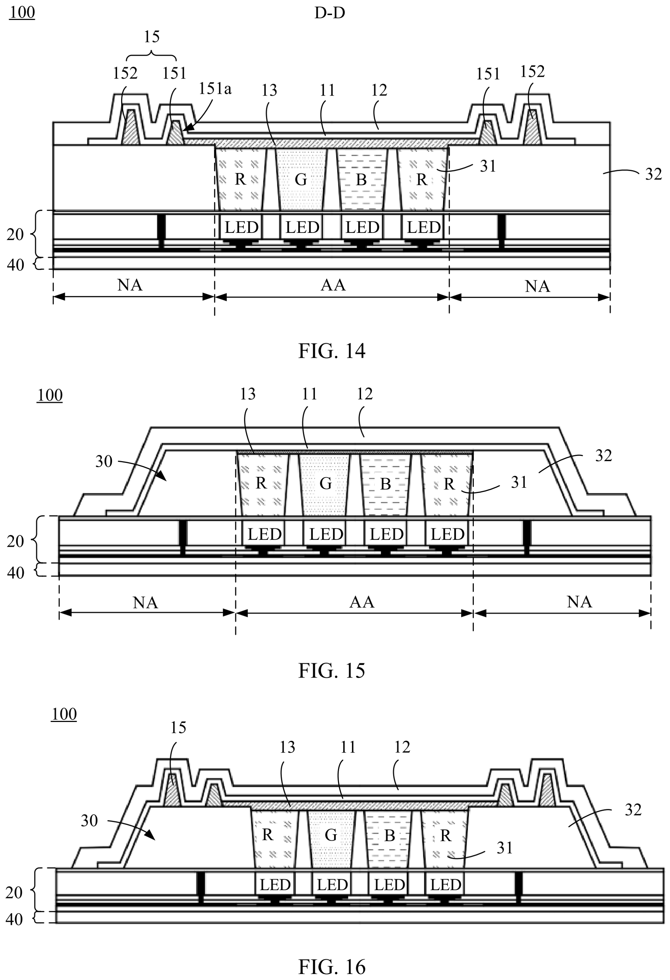

In an embodiment, refer to both FIG. 13 and FIG. 14. FIG. 13 is a diagram of a structure from a perspective of a side of the display panel 100 in an embodiment. FIG. 14 is a diagram of a cross-sectional structure of the display panel 100 at a location D-D in the embodiment shown in FIG. 13. As shown in FIG. 13 and FIG. 14, the encapsulation module 10 includes at least one blocking plate 15. The blocking plate 15 is disposed around a periphery of a plurality of quantum dot units 31, that is, the blocking plate 15 is disposed around a periphery of the display area AA. The first encapsulation layer 11 covers the blocking plate 15, to increase a diffusion path of water and oxygen permeation, further suppress water and oxygen diffusion, and reduce a water vapor transmission rate of the display panel 100. In other words, the blocking plate 15 is disposed around the periphery of the display area AA, so that encapsulation effect of the encapsulation module 10 can be further improved, to ensure working stability and working effect of each functional structure in the display panel 100.

For example, in the embodiment shown in FIG. 13, the blocking plate 15 includes a first blocking plate 151 and a second blocking plate 152, and both the first blocking plate 151 and the second blocking plate 152 are disposed around the periphery of the display area AA. The first blocking plate 151 is closer to the LED light-emitting unit 21 than the second blocking plate 152.

As shown in FIG. 14, in a direction in which the substrate 40 and the backlight module 20 are opposite to each other, a height of the first blocking plate 151 is less than a height of the second blocking plate 152, to further increase a diffusion path of water and oxygen permeation and further suppress water and oxygen diffusion.

In the embodiments shown in FIG. 13 and FIG. 14, an example in which there are two blocking plates 15 is used for description, and a quantity of blocking plates 15, an arrangement location, a structural size, and the like are not limited thereto. In another embodiment of this application, the quantity of blocking plates 15, the arrangement location, the structural size, and the like may be adjusted based on an actual design requirement. This is not specifically limited in this application.

For example, in an embodiment, a quantity of the blocking plates 15 is one to six. The quantity of the blocking plates 15 is set to one to six, so that the quantity of the blocking plates 15 can be adjusted based on an actual design requirement of the display panel 100, to improve encapsulation effect of the display panel 100. In this way, the display panel 100 is applicable to more application scenarios.

For example, in an embodiment, heights of a plurality of blocking plates 15 are equal.

In an embodiment, refer to FIG. 14. As shown in FIG. 14, the buffer layer 13 is accommodated in the blocking plate 15, and a thickness of the buffer layer 13 in the display area AA ranges from 30 nm to 5 µm.

For example, in the embodiment shown in FIG. 14, the first blocking plate 151 is disposed around the periphery of the display area AA, and has a side surface 151a away from the second blocking plate 152. The buffer layer 13 completely covers the display area AA, and extends into the edge area NA and abuts against the side surface 151a of the first blocking plate 151, to form effect of limiting a boundary of the buffer layer 13 by using the first blocking plate 151.

The buffer layer 13 is accommodated in the blocking plate 15, so that the blocking plate 15 can limit the boundary of the buffer layer 13, to implement anti-overflow effect for the buffer layer 13.

In this case, a thickness of the buffer layer 13 limited to the blocking plate 15 may be increased, so that the thickness of the buffer layer 13 in the display area AA ranges from 30 nm to 5 µm. This can reduce difficulty in controlling the thickness of the buffer layer 13 in a manufacturing process, and improve preparation effect and quality of the buffer layer 13. In addition, increasing the thickness of the buffer layer 13 can improve protection effect of the buffer layer 13 on the quantum dot unit 31, and improve flattening effect of the buffer layer 13, to facilitate subsequent film layer manufacturing, and further improve encapsulation effect of the encapsulation module 10.

In an embodiment, FIG. 15 is a diagram of a structure from a perspective of a side of the display panel 100 according to an embodiment. As shown in FIG. 15, a size of the backlight module 20 is greater than a size of the color conversion module 30, and an edge that is of the second encapsulation layer 12 and that exceeds the first encapsulation layer 11 is attached to the backlight module 20. In other words, a projection of the color conversion module 30 on the backlight module 20 is accommodated in the backlight module 20. In the edge area NA, the second encapsulation layer 12 is partially attached to the backlight module 20.

For example, in the embodiment shown in FIG. 15, the quantum dot pixel definition layer 32 of the color conversion module 30 extends into the edge area NA, and partially covers the edge area NA. In other words, in the edge area NA, the quantum dot pixel definition layer 32 partially covers a surface that is of the backlight module 20 and that is away from the substrate 40. It may be understood that "partially covered" means that the quantum dot pixel definition layer 32 does not completely cover the surface that is of the backlight module 20 and that is away from the substrate 40, so that the surface that is of the backlight module 20 and that is away from the substrate 40 is partially exposed to the outside.

As shown in FIG. 15, in the edge area NA, the first encapsulation layer 11 is attached to an exposed surface of the quantum dot pixel definition layer 32, to form effect that the first encapsulation layer 11 completely covers the quantum dot pixel definition layer 32. It is easily figured out that the first encapsulation layer 11 is disposed to extend to be attached to the backlight module 20, to expand a coverage size and an encapsulation range of the first encapsulation layer 11, so that effect of encapsulating the display panel 100 by the first encapsulation layer 11 can be further improved.

In the edge area NA, the second encapsulation layer 12 is attached to the surface that is of the first encapsulation layer 11 and that is away from the substrate 40 and a part of a surface that is of the backlight module 20 and that is away from the substrate 40, to form a case in which the second encapsulation layer 12 completely covers the first encapsulation layer 11, and covers a part of an exposed surface of the backlight module 20.

In the embodiment shown in FIG. 15, the surface that is of the backlight module 20 and that is away from the substrate 40 is the surface that is of the electrode layer 24 and that is away from the substrate 40, and the second encapsulation layer 12 covers the part of the exposed surface of the backlight module 20. In other words, the second encapsulation layer 12 covers a part of the surface that is of the electrode layer 24 and that is away from the substrate 40. It may be understood that the second encapsulation layer 12 is attached to the electrode layer 24 beyond an edge of the first encapsulation layer 11, so that closed space is formed between the second encapsulation layer 12 and the electrode layer 24, and a functional structure located between the second encapsulation layer 12 and the electrode layer 24 can be completely encapsulated, to further improve encapsulation effect of the encapsulation module 10.

The projection of the color conversion module 30 on the backlight module 20 is set to be accommodated in the backlight module 20, so that the second encapsulation layer 12 can extend to be attached to the backlight module 20, to completely encapsulate the entire color conversion module 30. In addition, the second encapsulation layer 12 is attached to the backlight module 20, so that a vertical distance at which edge water vapor diffuses into the display panel 100 is increased. This helps suppress water and oxygen diffusion, and reduce a water vapor transmission rate of the display panel 100. This further reduces a risk that the quantum dot unit 31 fails due to water and oxygen erosion, and further improves working stability of the quantum dot unit 31.

The second encapsulation layer 12 is disposed to be attached to the backlight module 20, so that a guard ring (Guard ring) structure can be formed around the display panel 100, to avoid possible adverse impact of chipping effect on edge encapsulation effect of the encapsulation module 10 in a subsequent process of cutting the display panel 100.

In an embodiment, FIG. 16 is a diagram of a structure from a perspective of a side of the display panel 100 according to an embodiment. In the embodiment shown in FIG. 16, when the second encapsulation layer 12 completely encapsulations the color conversion module 30, and the second encapsulation layer 12 is attached to the surface that is of the backlight module 20 and that is away from the substrate 40, the blocking plate 15 is disposed on a periphery of the display area AA.

For example, as shown in FIG. 16, the blocking plate 15 is located in the edge area NA, and is located on a side that is of the quantum dot pixel definition layer 32 and that is away from the substrate 40. The first encapsulation layer 11 completely covers the blocking plate 15.

An arrangement quantity, locations, structural sizes, and the like of blocking plates 15 may be the same as the arrangement quantity, the locations, the structural sizes, and the like of blocking plates 15 in the embodiment shown in FIG. 14. Beneficial effects generated by the blocking plate 15 are also the same as those generated by the blocking plate 15 in the embodiment shown in FIG. 14. Details are not described herein again.

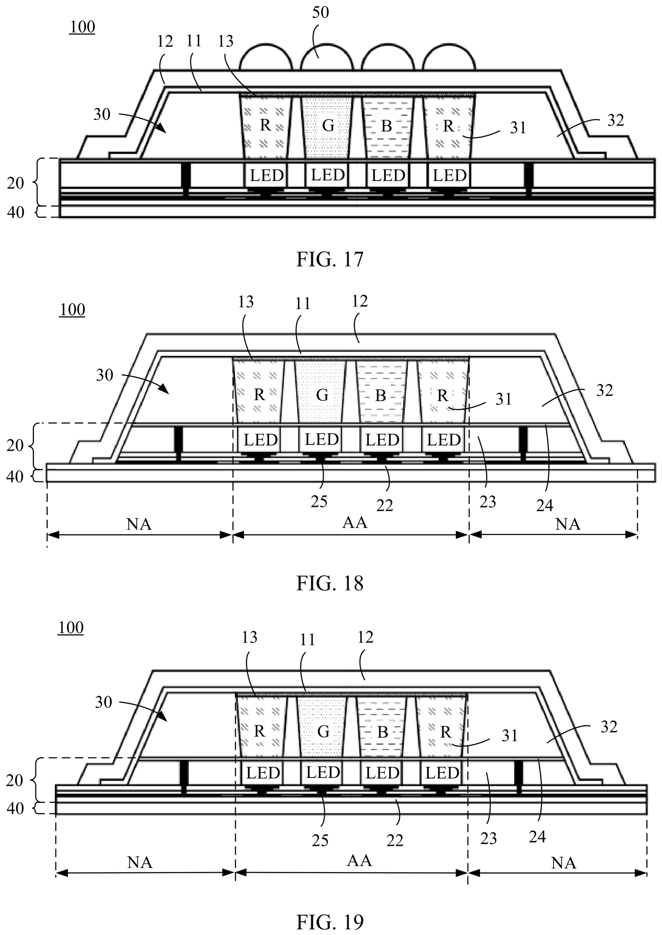

In an embodiment, FIG. 17 is a diagram of a structure from a perspective of a side of the display panel 100 according to an embodiment. In the embodiment shown in FIG. 17, when the second encapsulation layer 12 completely encapsulates the color conversion module 30, and the second encapsulation layer 12 is attached to a surface that is of the backlight module 20 and that is away from the substrate 40, the optical functional module 50 may be disposed on a side that is of the encapsulation module 10 and that is away from the substrate 40, to adjust and control a light shape of light emitted by the backlight module 20 or the color conversion module 30.

An arrangement quantity, locations, and the like of optical functional modules 50 may be the same as the arrangement quantity, the locations, and the like of optical functional modules 50 in the embodiments shown in FIG. 10 to FIG. 12. Beneficial effects generated by the optical functional modules 50 are also the same as those of the optical functional modules 50 in the embodiments shown in FIG. 10 to FIG. 12. Details are not described herein again.

The second encapsulation layer 12 is partially attached to surfaces of functional structures in the backlight module 20. An edge that is of the second encapsulation layer 12 and that exceeds the first encapsulation layer 11 is attached to at least one of the electrode layer 24, the filling layer 23, the bonding layer 25, and the driver backplane 22.

In an embodiment, FIG. 18 is a diagram of a structure from a perspective of a side of the display panel 100 according to an embodiment. For example, in the embodiment shown in FIG. 18, the color conversion module 30, and projections of the electrode layer 24, the bonding layer 25, and the filling layer 23 of the backlight module 20 on the driver backplane 22 are all accommodated in the driver backplane 22. In this way, a surface that is of the driver backplane 22 and that is away from the substrate 40 is exposed.

In the edge area NA, the first encapsulation layer 11 is attached to exposed surfaces of the quantum dot pixel definition layer 32, the electrode layer 24, the filling layer 23, and the bonding layer 25, and is attached to a part of a surface that is of the driver backplane 22 and that is away from the substrate 40. In this way, closed space is formed between the driver backplane 22 and the first encapsulation layer 11, and a coverage size and an encapsulation range of the first encapsulation layer 11 are expanded, to further improve encapsulation effect of the first encapsulation layer 11 on the display panel 100.

In the edge area NA, the second encapsulation layer 12 is attached to an exposed surface of the first encapsulation layer 11, and is partially attached to the surface that is of the driver backplane 22 and that is away from the substrate 40.

The second encapsulation layer 12 is disposed to be partially attached to the driver backplane 22, so that closed space is formed between the second encapsulation layer 12 and the driver backplane 22, to completely encapsulate a functional structure that is of the display panel 100 and that is located between the second encapsulation layer 12 and the driver backplane 22. To be specific, when the second encapsulation layer 12 is attached to the driver backplane 22, structures such as the plurality of LED light-emitting units 21, a metal wire arranged on the driver backplane 22, and a pad configured to be bonded to the LED light-emitting unit 21 can all be completely encapsulated. This avoids a reaction like oxidation of the metal wire, the pad, or the like caused by water and oxygen erosion, which affects working reliability of the backlight module 20. The second encapsulation layer 12 is disposed to be partially attached to the driver backplane 22, so that encapsulation effect of the encapsulation module 10 can be further improved.

The second encapsulation layer 12 is disposed to be partially attached to the driver backplane 22, so that a guard ring structure can be formed around the display panel 100, to increase a vertical distance at which edge water vapor diffuses into the display panel 100 and suppress water and oxygen diffusion. This reduces possible adverse impact of chipping effect on edge encapsulation effect of the encapsulation module 10 in a cutting process of the display panel 100.

In an embodiment, FIG. 19 is a diagram of a structure from a perspective of a side of the display panel 100 according to an embodiment. In the embodiment shown in FIG. 18, the color conversion module 30, and projections of the filling layer 23 and the electrode layer 24 of the backlight module 20 on the bonding layer 25 are all accommodated in the bonding layer 25, so that a surface that is of the bonding layer 25 and that is away from the substrate 40 is exposed.

In the edge area NA, the first encapsulation layer 11 is attached to exposed surfaces of the quantum dot pixel definition layer 32, the electrode layer 24, and the filling layer 23, and is attached to the surface that is of the bonding layer 25 and that is away from the substrate 40, so that functional structures between the bonding layer 25 and the first encapsulation layer 11 are completely encapsulated, to further improve effect of encapsulating the display panel 100 by the first encapsulation layer 11.

In the edge area NA, the second encapsulation layer 12 is attached to an exposed surface of the first encapsulation layer 11, and is partially attached to the surface that is of the bonding layer 25 and that is away from the substrate 40.

The second encapsulation layer 12 is disposed to be partially attached to the bonding layer 25, so that closed space is formed between the second encapsulation layer 12 and the bonding layer 25, to completely encapsulate a functional structure that is of the display panel 100 and that is located between the second encapsulation layer 12 and the bonding layer 25. To be specific, when the second encapsulation layer 12 is attached to the bonding layer 25, the plurality of LED light-emitting units 21 can be completely encapsulated, to avoid a reaction like oxidation of the plurality of LED light-emitting units 21 caused by water and oxygen erosion, and avoid impact on working reliability of the backlight module 20.

In an embodiment, in the edge area NA, an edge that is of the second encapsulation layer 12 and that exceeds the first encapsulation layer 11 is attached to the filling layer 23. It may be understood that the second encapsulation layer 12 is disposed to be partially attached to the filling layer 23, so that closed space is formed between the second encapsulation layer 12 and the filling layer 23, to completely encapsulate a functional structure that is of the display panel 100 and that is located between the second encapsulation layer 12 and the filling layer 23, and further improve encapsulation effect of the encapsulation module 10.

The second encapsulation layer 12 is disposed to be partially attached to the filling layer 23, so that a guard ring structure can be formed around the display panel 100, to increase a vertical distance at which edge water vapor diffuses into the display panel 100 and suppress water and oxygen diffusion. This reduces possible adverse impact of chipping effect on edge encapsulation effect of the encapsulation module 10 in a cutting process of the display panel 100.

In an embodiment, in the edge area NA, an edge that is of the second encapsulation layer 12 and that exceeds the first encapsulation layer 11 is attached to more of the driver backplane 22, the filling layer 23, and the electrode layer 24.

In this embodiment of this application, an example in which the first encapsulation layer 11 and the second encapsulation layer 12 are attached to one or more of the electrode layer 24, the filling layer 23, the bonding layer 25, and the driver backplane 22 in the backlight module 20 is used for description. That the first encapsulation layer 11 and the second encapsulation layer 12 can be attached to one or more of the electrode layer 24, the filling layer 23, the bonding layer 25, and the driver backplane 22 in the backlight module 20 is not limited.

To meet different light-emitting requirements, another functional structure layer may be further disposed in the backlight module 20. In another embodiment of this application, the first encapsulation layer 11 and the second encapsulation layer 12 may be further disposed to be attached to the another functional structure layer in the backlight module 20. In this way, different encapsulation effect of the encapsulation module 10 on the display panel 100 is implemented. This is not specifically limited in embodiments of this application.

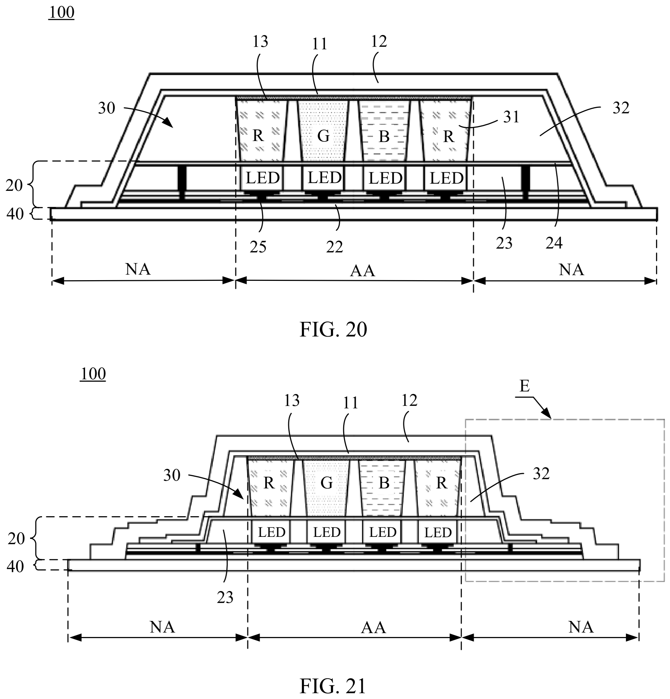

In an embodiment, FIG. 20 is a diagram of a structure from a perspective of a side of the display panel 100 according to an embodiment. As shown in FIG. 20, a projection of the backlight module 20 on the substrate 40 is accommodated in the substrate 40, and in the edge area NA, the second encapsulation layer 12 is partially attached to the substrate 40.

For example, in the embodiment shown in FIG. 20, projections of the color conversion module 30 and the backlight module 20 on the substrate 40 are both accommodated in the substrate 40, so that a part of a surface of the substrate 40 is exposed. In the edge area NA, the first encapsulation layer 11 is attached to exposed surfaces of the quantum dot pixel definition layer 32, the electrode layer 24, the filling layer 23, the bonding layer 25, and the driver backplane 22, and is attached to a part of an exposed surface of the substrate 40.

It may be understood that the first encapsulation layer 11 is disposed to extend to be attached to the substrate 40, to expand a coverage size and an encapsulation range of the first encapsulation layer 11, so that effect of encapsulating the display panel 100 by the first encapsulation layer 11 can be further improved.

In the edge area NA, the second encapsulation layer 12 is attached to an exposed surface of the first encapsulation layer 11, and is attached to the part of the exposed surface of the substrate 40.

The projection of the backlight module 20 on the substrate 40 is set to be accommodated in the substrate 40, so that the second encapsulation layer 12 can extend to be attached to the substrate 40, and the second encapsulation layer 12 can implement complete encapsulation effect for the color conversion module 30 and the backlight module 20. A range in which the second encapsulation layer 12 completely encapsulates each functional structure in the display panel 100 is expanded, to further improve encapsulation effect of the encapsulation module 10 and improve working performance of the display panel.

The second encapsulation layer 12 is attached to the substrate 40, so that a guard ring structure can be formed around the display panel 100, a vertical distance at which edge water vapor diffuses into the display panel 100 is further increased, and impact of subsequent cutting on edge encapsulation of the encapsulation module 10 can be further reduced.

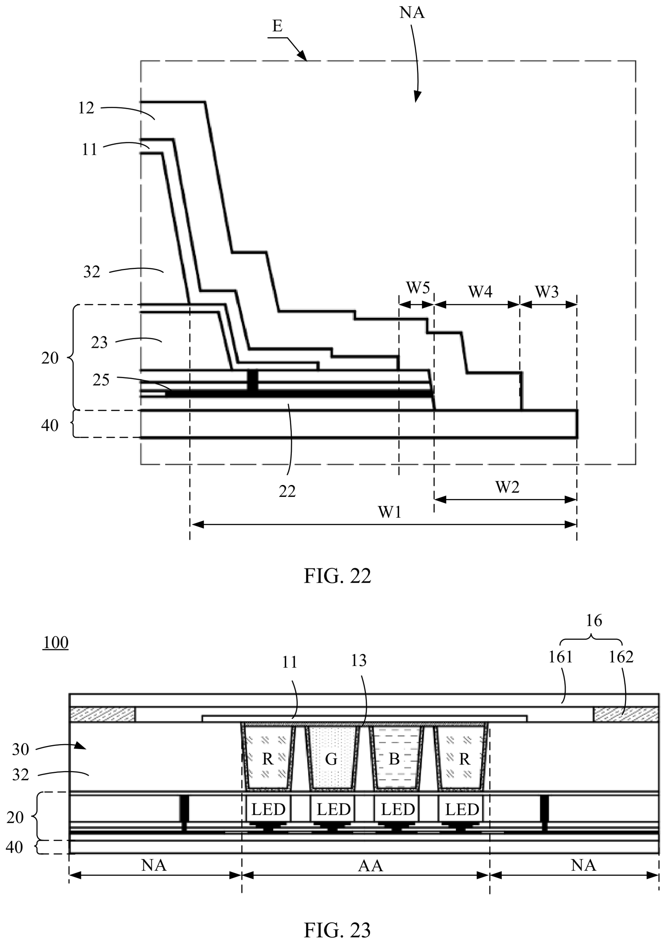

In an embodiment, refer to both FIG. 21 and FIG. 22. FIG. 21 is a diagram of a structure from a perspective of a side of the display panel 100 in an embodiment. FIG. 22 is an enlarged diagram of a partial structure of the display panel 100 at a location E in the embodiment in FIG. 21. As shown in FIG. 21, there is a first distance W1 between an outer edge of the color conversion module 30 and an outer edge of the substrate 40, there is a second distance W2 between an outer edge of the backlight module 20 and the outer edge of the substrate 40, the first distance W1 is greater than the second distance W2, and the encapsulation module 10 is in a stepped shape in the edge area NA.

In a process of preparing the backlight module 20 and the color conversion module 30, the filling layer 23 and the quantum dot pixel definition layer 32 are disposed at different etching angles in the edge area NA. In this way, the first encapsulation layer 11 and the second encapsulation layer 12 are in a stepped shape on a periphery of the filling layer 23 and a periphery of the quantum dot pixel definition layer 32.

For example, in the embodiment shown in FIG. 20, the first distance W1 between the outer edge of the color conversion module 30 and the outer edge of the substrate 40 is greater than the second distance W2 between the outer edge of the backlight module 20 and the outer edge of the substrate 40. A projection of the color conversion module 30 on the backlight module 20 is accommodated in the backlight module 20, so that when the first encapsulation layer 11 and the second encapsulation layer 12 encapsulate the display panel 100 in a direction from the quantum dot pixel definition layer 32 to the substrate 40, the first encapsulation layer 11 and the second encapsulation layer 12 present a plurality of step-shaped structures in the edge area NA.

It may be understood that, the first distance W1 is set to be greater than the second distance W2, and the encapsulation module 10 is in a stepped shape in the edge area NA, so that a distance at which edge water vapor diffuses into the display panel 100 can be increased, to achieve effect of suppressing water and oxygen diffusion. This further reduces a water vapor transmission rate of the display panel 100, and improves effect of encapsulating the display panel 100 by the encapsulation module 10.

The encapsulation module 10 is in a stepped shape in the edge area NA, so that a bonding size between film layers of the encapsulation module 10 is increased, and adhesion effect between the film layers is improved. This reduces a risk of peeling off the film layers in a cutting process, and this improves edge encapsulation effect of the encapsulation module 10.

In the embodiments shown in FIG. 21 and FIG. 22, an example in which the encapsulation module 10 is provided with a stepped structure on a periphery of both the color conversion module 30 and the backlight module 20 is used for description. However, that the encapsulation module 10 is formed in a stepped manner on the periphery of both the color conversion module 30 and the backlight module 20 is not limited. A location at which the encapsulation module 10 is provided with a stepped shape in the edge area NA may be adjusted based on an actual design requirement. This is not specifically limited in embodiments of this application.

For example, in an embodiment, the encapsulation module 10 is in a stepped shape on a periphery of the color conversion module 30.

For example, in an embodiment, the encapsulation module 10 is in a stepped shape on a periphery of the backlight module 20.

In an embodiment, refer to FIG. 22. A distance between an outer edge of the encapsulation module 10 and an outer edge of the substrate 40 ranges from 50 µm to 150 µm. In the embodiment shown in FIG. 22, the distance between the outer edge of the encapsulation module and the outer edge of the substrate 40 is a third distance W3, and the third distance W3 ranges from 50 µm to 150 µm.

It may be understood that the third distance W3 is set to ranging from 50 µm to 150 µm, to avoid damage to a film layer of the encapsulation module 10 caused by chipping effect in a process of cutting the display panel 100, for example, causing peeling between film layers, or affecting edge encapsulation effect of the encapsulation module 10.

The distance between the outer edge of the encapsulation module 10 and the outer edge of the substrate 40 is set to ranging from 50 µm to 150 µm, so that edge encapsulation effect of the encapsulation module 10 can be ensured, and working performance of the display panel 100 can be further improved.

In an embodiment, refer to FIG. 22. A distance between the outer edge of the encapsulation module 10 and an outer edge of the backlight module 20 ranges from 50 µm to 100 µm. In the embodiment shown in FIG. 22, the distance between the outer edge of the encapsulation module 10 and the outer edge of the backlight module 20 is a fourth distance W4, and the fourth distance W4 ranges from 50 µm to 100 µm, to protect a side wall of the driver backplane 22. In addition, edge encapsulation effect of the encapsulation module 10 is improved.

In an embodiment, refer to FIG. 22. A distance between an outer edge of the first encapsulation layer 11 and the outer edge of the backlight module 20 is greater than 50 µm. In the embodiment shown in FIG. 22, the distance between the outer edge of the first encapsulation layer 11 and the outer edge of the backlight module 20 is a fifth distance W5, and the fifth distance W5 is greater than 50 µm. This can ensure that the second encapsulation layer 12 well covers an edge of the first encapsulation layer 11, to further improve edge encapsulation effect of the encapsulation module 10.

In an embodiment, in the edge area NA, a height of a step structure formed by the first encapsulation layer 11 ranges from 2 µm to 10 µm, and a width of the step structure formed by the first encapsulation layer 11 ranges from 0.2 µm to 50 µm.

In an embodiment, in the edge area NA, a height of a step structure formed by the second encapsulation layer 12 ranges from 2 µm to 10 µm, and a width of the step structure formed by the second encapsulation layer 12 ranges from 0.2 µm to 50 µm.

It may be understood that the "height" of the step structure is a distance of the step shape formed by the first encapsulation layer 11 or the second encapsulation layer 12 in the edge area NA in a direction of the substrate 40 relative to the backlight module 20. The "width" of the step structure is a distance of the step shape formed by the first encapsulation layer 11 or the second encapsulation layer 12 in the edge area NA in a plane direction of the display panel 100.

In an embodiment, FIG. 23 is a diagram of a structure from a perspective of a side of the display panel 100 according to an embodiment. As shown in FIG. 23, the encapsulation module 10 includes a cover assembly 16. The cover assembly 16 includes an encapsulation cover 161 and a support ring 162. The encapsulation cover 161 is located on a side that is of the first encapsulation layer 11 and that is away from the buffer layer 13. The encapsulation cover 161 and the first encapsulation layer 11 are spaced from each other, the support ring 162 is disposed around a periphery of the first encapsulation layer 11 and is configured to support the encapsulation cover 161, and the support ring 162 and the encapsulation cover 161 work together to encapsulate the display panel 100.

In the embodiment shown in FIG. 23, in the edge area NA, the support ring 162 is fastened to the color conversion module 30. For example, the quantum dot pixel definition layer 32 of the color conversion module 30 completely covers the edge area NA, and the support ring 162 is in the edge area NA and is connected between the quantum dot pixel definition layer 32 and the encapsulation cover 161, to form effect of completely sealing the first encapsulation layer 11.

The support ring 162 is disposed to be fastened to the color conversion module 30, so that the encapsulation cover 161 and the support ring 162 cooperate with each other to encapsulate the first encapsulation layer 11 and an edge of the first encapsulation layer 11, so as to further encapsulate the display panel 100.

In the embodiment shown in FIG. 23, the support ring 162 is disposed in the edge area NA, so that support effect can be formed on the encapsulation cover 161, and the encapsulation cover 161 and the first encapsulation layer 11 are spaced from each other, to prevent the encapsulation cover 161 from squeezing the first encapsulation layer 11. Therefore, encapsulation effect of the first encapsulation layer 11 can be ensured.

Through cooperation between the support ring 162 and the encapsulation cover 161, effect of encapsulating the first encapsulation layer 11 can also be implemented, and effect of further encapsulating the display panel 100 can also be implemented based on the first encapsulation layer 11. In this way, a water vapor transmission rate of the display panel 100 is less than 5×10⁻⁶ g/m²/day. The cover assembly 16 is disposed to encapsulate the first encapsulation layer 11 and further encapsulate the display panel 100, so that difficulty in an encapsulation process can be reduced, and a possible undesirable phenomenon like peeling or fracture of a multi-film layer structure can be avoided.

In an embodiment, a material of the encapsulation cover 161 may be a transparent glass material.

In an embodiment, a material of the support ring 162 includes any one of a glass slurry, magnesium oxide, calcium oxide, barium oxide, lithium oxide, sodium oxide, potassium oxide, zinc oxide, aluminum oxide, tin oxide, iron oxide, copper oxide, tungsten oxide, borosilicate lead glass, tin phosphate glass, and vanadate glass.

Materials of the glass slurry, magnesium oxide, calcium oxide, barium oxide, lithium oxide, sodium oxide, potassium oxide, zinc oxide, aluminum oxide, tin oxide, iron oxide, copper oxide, tungsten oxide, borosilicate lead glass, tin phosphate glass, and vanadate glass can implement curing and water-oxygen blocking effect after being irradiated by a laser or infrared, so that the support ring 162 can support the encapsulation cover 161 and work together with the encapsulation cover 161, to achieve good water-oxygen blocking effect.

In FIG. 23, an example in which the support ring 162 is located between the color conversion module 30 and the encapsulation cover 161 is used for description, and an arrangement location of the support ring 162 is not limited thereto. In another embodiment of this application, the arrangement location of the support ring 162 may be adjusted based on an actual design of each functional structure in the display panel 100.

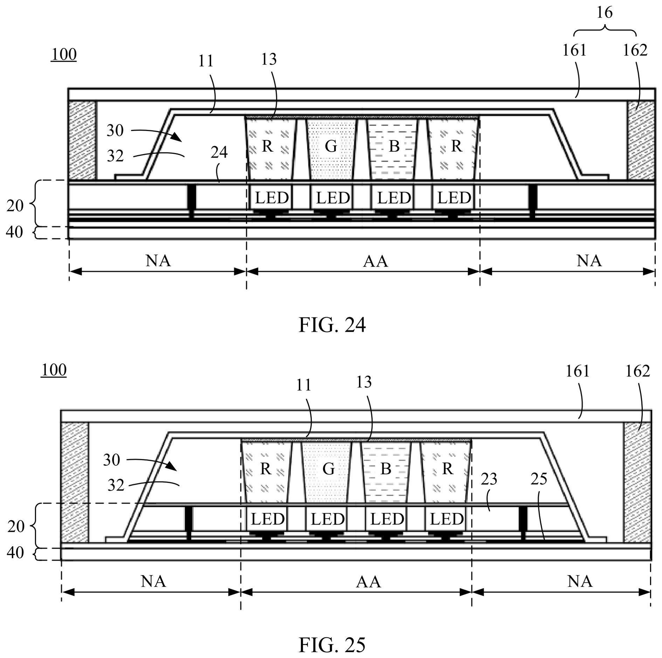

In an embodiment, FIG. 24 is a diagram of a structure from a perspective of a side of the display panel 100 according to an embodiment. As shown in FIG. 24, in the edge area NA, the support ring 162 is fastened to the backlight module 20.

In the embodiment shown in FIG. 24, a projection of the color conversion module 30 on the backlight module 20 is accommodated in the backlight module 20, so that a part of a surface that is of the backlight module 20 and that is away from the substrate 40 is exposed. The first encapsulation layer 11 covers the quantum dot pixel definition layer 32 of the color conversion module 30, and the first encapsulation layer 11 is at least partially attached to the surface that is of the backlight module 20 and that is away from the substrate 40.

A surface that is of the electrode layer 24 and that is away from the substrate 40 is constructed as the surface that is of the backlight module 20 and that is away from the substrate 40. The support ring 162 is connected between the backlight module 20 and the encapsulation cover 161, that is, the support ring 162 is connected between the electrode layer 24 and the encapsulation cover 161.

The support ring 162 is disposed to be fastened to the backlight module 20, so that the encapsulation cover 161 and the support ring 162 cooperate with each other to completely encapsulate the entire color conversion module 30. This further reduces a risk that the quantum dot unit 31 fails due to water and oxygen erosion. In this way, working stability of the quantum dot unit 31 is improved.

In an embodiment, FIG. 25 is a diagram of a structure from a perspective of a side of the display panel 100 according to an embodiment. As shown in FIG. 25, in the edge area NA, the support ring 162 is fastened to the driver backplane 22.

In the embodiment shown in FIG. 25, projections of the color conversion module 30, the electrode layer 24, the filling layer 23, and the bonding layer 25 on the driver backplane 22 are all accommodated in the driver backplane 22, to expose at least a part of a surface of the driver backplane 22. The first encapsulation layer 11 covers the quantum dot pixel definition layer 32 of the color conversion module 30 and the electrode layer 24, the filling layer 23, and the bonding layer 25 of the backlight module 20. In addition, the first encapsulation layer 11 is at least partially attached to the surface that is of the driver backplane 22 and that is away from the substrate 40.

The support ring 162 is connected between the driver backplane 22 and the encapsulation cover 161. The support ring 162 is disposed and connected between the driver backplane 22 and the encapsulation cover 161, so that the encapsulation cover 161 and the support ring 162 cooperate with each other, to completely encapsulate the entire color conversion module 30 and the plurality of LED light-emitting units 21 in the backlight module 20. An encapsulation range of the cover assembly 16 is further expanded, to improve encapsulation effect of the encapsulation module 10.

In the embodiment shown in FIG. 25, an example in which the support ring 162 is fixedly disposed on the driver backplane 22 is used for description, and the support ring 162 is not limited to being connected only to the driver backplane 22 in the backlight module 20. In other words, the support ring 162 may alternatively be connected to another functional structure layer in the backlight module 20, to implement different encapsulation effect and meet different design requirements.

In another embodiment of this application, the support ring 162 may alternatively be connected to another functional structure layer in the backlight module 20.

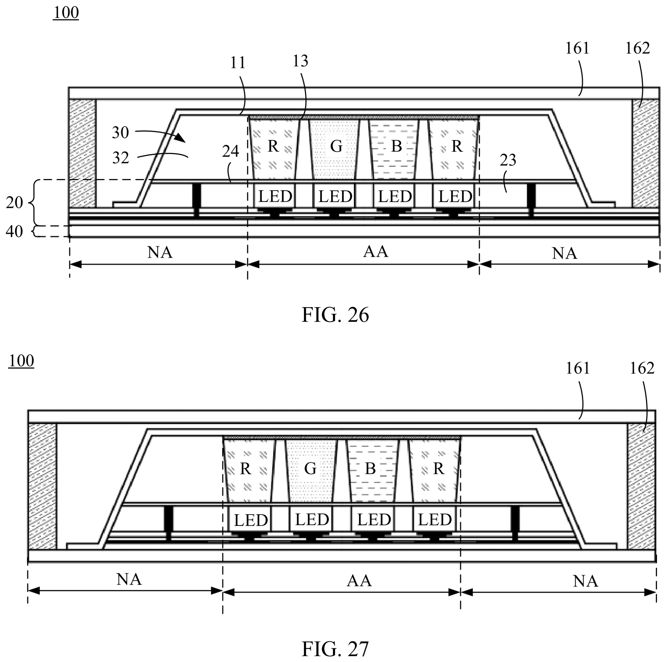

For example, in an embodiment, FIG. 26 is a diagram of a structure from a perspective of a side of the display panel 100 according to an embodiment. In the edge area NA, the support ring 162 is fastened to the bonding layer 25.

For example, in an embodiment, in the edge area NA, the support ring 162 is fastened to the filling layer 23.

In an embodiment of this application, FIG. 27 is a diagram of a structure from a perspective of a side of the display panel 100 according to an embodiment. In the edge area NA, the support ring 162 is fastened to the substrate 40.

For example, in the embodiment shown in FIG. 27, projections of the backlight module 20 and the color conversion module 30 on the substrate 40 are both accommodated on the substrate 40, so that at least a part of a surface of the substrate 40 is exposed to the outside.

The first encapsulation layer 11 covers the backlight module 20 and the color conversion module 30, and is at least partially attached to the substrate 40.

The support ring 162 is connected between the substrate 40 and the encapsulation cover 161, so that the support ring 162 and the encapsulation cover 161 can completely encapsulate the color conversion module 30 and the backlight module 20. This expands a range in which the cover assembly 16 completely encapsulates each functional structure in the display panel 100. This further improves encapsulation effect of the encapsulation module 10, and improves working performance of the display panel 100.

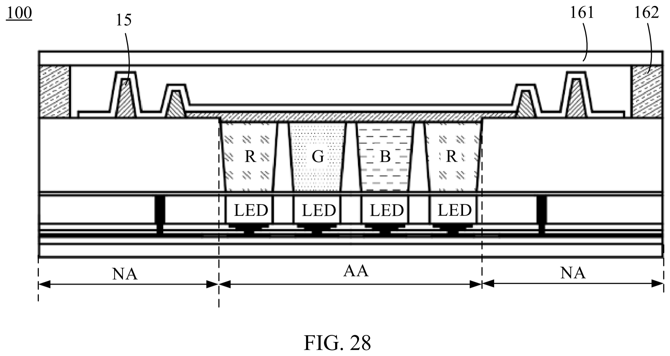

In an embodiment, FIG. 28 is a diagram of a structure from a perspective of a side of the display panel 100 according to an embodiment. In the embodiment shown in FIG. 28, when the first encapsulation layer 11 is encapsulated through the cover assembly 16, and the display panel 100 is further encapsulated, the blocking plate 15 may be disposed in the edge area NA.

Arrangement locations, structure settings, an arrangement quantity, and the like of blocking plates 15 are the same as the arrangement locations, the structure settings, and the arrangement quantity of blocking plates 15 in the embodiment shown in FIG. 14. Technical effect achieved by the blocking plates 15 is also the same as that achieved by the blocking plate 15 in the embodiment shown in FIG. 14. Details are not described herein again.

An ALD encapsulation film layer of the quantum dot unit is usually produced by using a metal-organic precursor. If an encapsulation film layer is directly produced on a surface of the quantum dot unit, the metal-organic precursor may chemically react with the quantum dot unit, causing damage to a surface of a quantum dot. Optical performance and light-emitting efficiency of the quantum dot layer are reduced, and working stability of the quantum dot unit is affected. Performance degradation of the quantum dot unit directly affects picture display effect of the display panel, and makes user experience poor.

However, in the encapsulation module 10 of the display panel 100 in this application, the buffer layer 13 is disposed between the color conversion module 30 and the first encapsulation layer 11, and the buffer layer 13 is disposed to cover the display area AA, so that the buffer layer 13 can protect each quantum dot unit 31. This avoids a chemical reaction between the metal-organic precursor and the quantum dot unit 31 in a preparation process of the first encapsulation layer 11 during subsequent preparation of the first encapsulation layer 11, to damage a light-emitting surface of the quantum dot unit 31 and reduce stability and effectiveness of the quantum dot unit 31.

The buffer layer 13 is disposed to cover the display area AA, so that each quantum dot unit 31 can be preliminarily encapsulated, and encapsulation effect of each quantum dot unit 31 can be further improved.

The buffer layer 13 is disposed between the color conversion module 30 and the first encapsulation layer 11, so that flattening effect can be implemented on the surface that is of each quantum dot unit 31 and that is away from the substrate 40. This facilitates subsequent preparation of another film layer, and improves preparation effect and quality of the another film layer.

The first encapsulation layer 11 is disposed to cover the buffer layer 13 and partially extend into the edge area NA, so that a function of encapsulating the display panel 100 by the encapsulation module 10 can be implemented, to prevent water and oxygen from eroding each functional structure in the display panel 100. In this way, a water vapor transmission rate of the display panel 100 is less than 5×10⁻⁶ g/m²/day.

The quantum dot unit 31 is protected by the buffer layer 13, and the display panel 100 is encapsulated by the first encapsulation layer 11 to prevent the quantum dot unit 31 and another functional structure in the display panel 100 from being eroded by water and oxygen, so that stability and effectiveness of the quantum dot unit 31 can be ensured, picture display effect of the display panel 100 is improved, and user experience is further improved.

Further, because the electronic device 200 in this application uses the display panel 100 in any one of the foregoing embodiments, the electronic device 200 in this application has all possible beneficial effects of the display panel 100 in any one of the foregoing embodiments.

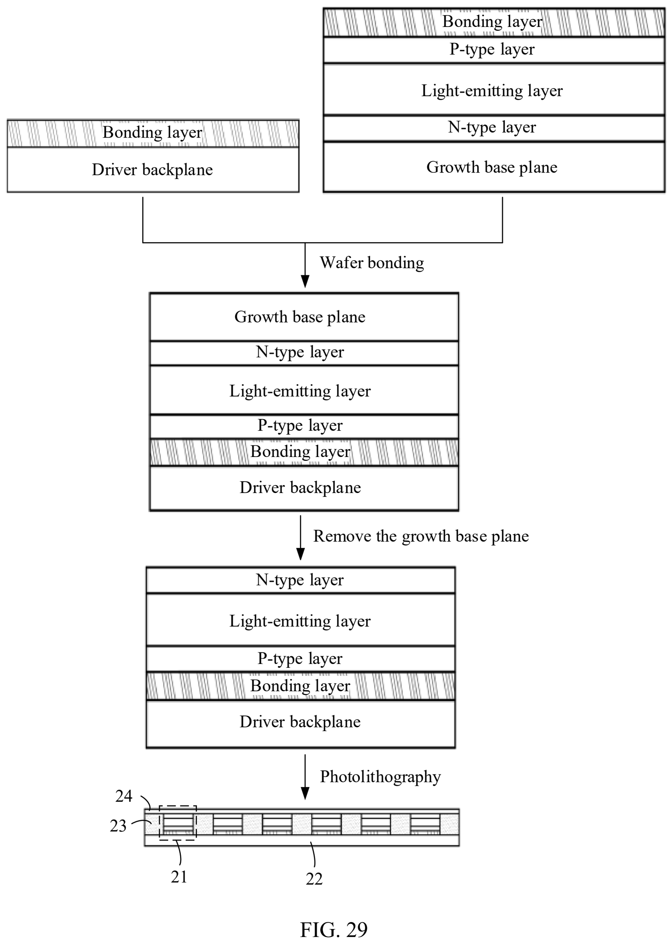

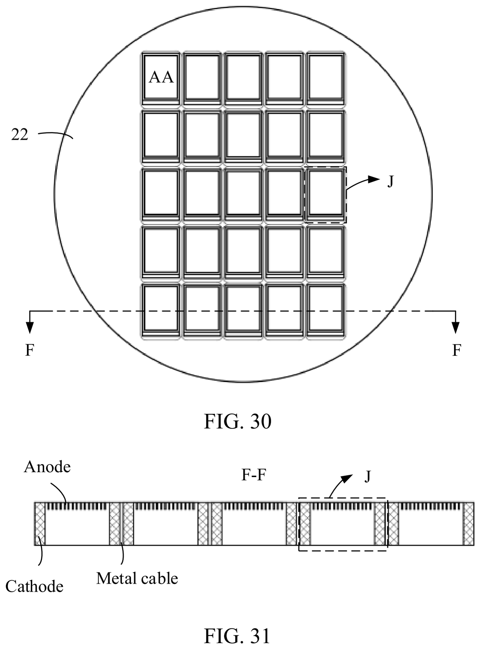

In this application, the display panel 100 may be a micro-LED display panel, and wafer-level encapsulation is implemented. In other words, a plurality of display panels 100 may be simultaneously produced and cut on a same wafer. For example, refer to FIG. 29 to FIG. 31. FIG. 29 is a schematic flowchart of preparing the LED light-emitting unit 21 according to an embodiment. FIG. 30 is a diagram of a structure from a perspective of a side of the backlight module 20 prepared in the embodiment shown in FIG. 29. FIG. 31 is a diagram of a structure from a perspective of a side of the backlight module 20 at a location F-F in the embodiment shown in FIG. 30.

In the embodiment shown in FIG. 29, an N-type layer, a light-emitting layer, and a P-type layer are sequentially grown in an area that is on a same growth base plane and that corresponds to a plurality of display panels 100. The N-type layer and the P-type layer work together to drive the light-emitting layer to emit light, and a bonding layer is further disposed on a side that is of the P-type layer and that is away from the growth base plane. The N-type layer, the light-emitting layer, and the P-type layer are constructed as an epitaxial wafer.

Then, the epitaxial wafer is bonded to the driver backplane 22, and the growth base plane is removed. There are also a plurality of driver backplanes 22, and the plurality of driver backplanes 22 are located on a same substrate. Locations of the plurality of driver backplanes 22 are disposed in a one-to-one correspondence with locations of the plurality of display panels 100.

Further, the driver backplane 22 may be etched through a photolithography process, to form a plurality of LED light-emitting unit groups J, where the LED light-emitting unit groups J are spaced from each other. This is not limited. A plurality of LED light-emitting units 21 are arranged in an array in each LED light-emitting unit group J, and the LED light-emitting units 21 are spaced from each other.

In the embodiment shown in FIG. 29, the LED light-emitting units 21 are flattened by using the filling layer 23, to improve bonding efficiency and bonding effect of the LED light-emitting units 21.

In FIG. 29, an embodiment of preparing the LED light-emitting unit 21 is used as an example for description. However, a preparation method and procedure of the LED light-emitting unit 21 in this embodiment of this application are not limited thereto. In another embodiment of this application, the preparation method and procedure of the LED light-emitting unit 21 may be adjusted based on an actual design and a process condition. This is not specifically limited in this application. In embodiments shown in FIG. 29, a structure, a shape, and the like of the LED light-emitting unit 21 are displayed as examples, but do not indicate an actual structure and shape of the LED light-emitting unit 21.

As shown in FIG. 30, a plurality of LED light-emitting unit groups J are formed on the driver backplane 22. Each LED light-emitting unit group J is configured to provide a light source for each display panel to display a picture. In other words, one LED light-emitting unit group J corresponds to one display panel.

In the embodiment shown in FIG. 30, a possible arrangement quantity and an arrangement manner of the LED light-emitting unit groups J are used as an example for description. However, the arrangement quantity and the arrangement manner of the LED light-emitting unit groups J arranged on the driver backplane 22 are not limited thereto. In another embodiment of this application, the arrangement quantity and the arrangement manner of the LED light-emitting unit groups J bonded to the driver backplane 22 may be adjusted based on an actual requirement. This is not limited in this application.

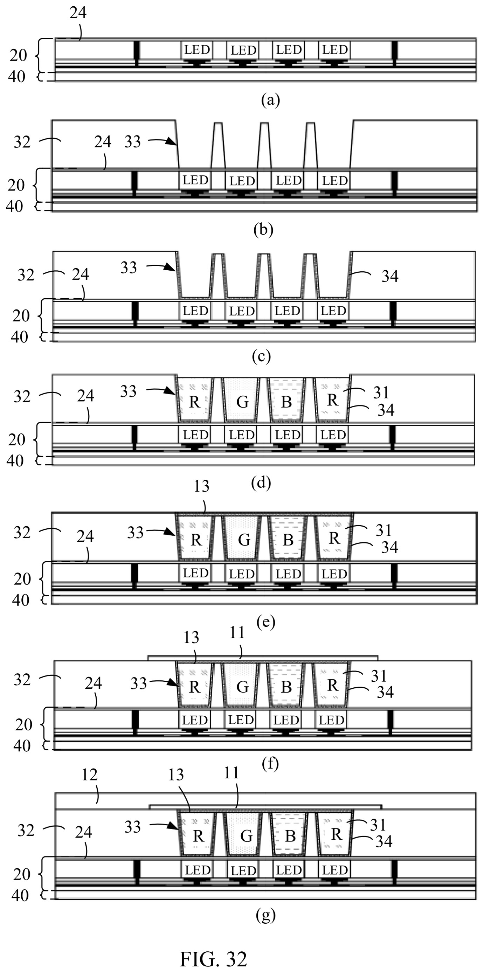

FIG. 32 is a schematic flowchart of preparing the display panel 100 in this application according to an embodiment. To clearly show a diagram of a preparation procedure of the display panel 100 in this application, in the embodiment shown in FIG. 32, an example in which the display panel 100 in the embodiment shown in FIG. 8 is prepared is used for description.

For example, in embodiments shown in (a) in FIG. 32 and in (b) in FIG. 32, the backlight module 20 is provided. The quantum dot pixel definition layer 32 is prepared on a surface of the backlight module 20, and a plurality of pixel holes 33 are prepared through processing. Each pixel hole 33 is disposed corresponding to a location of one LED light-emitting unit 21, so that light emitted by each LED light-emitting unit 21 can be emitted into a pixel hole 33 corresponding to the LED light-emitting unit 21.

A material of the quantum dot pixel definition layer 32 includes but is not limited to at least one of aluminum (Al), silver (Ag), platinum (Pt), gold (Au), copper (Cu), titanium (Ti), nickel (Ni), and chromium (Cr). The quantum dot pixel definition layer 32 is set to be made of a metal material with high thermal conductivity and high reflectivity, so that an operating temperature of the quantum dot unit 31 can be reduced, and sidewall light reflectivity of the quantum dot unit 31 can be improved. This improves light-emitting efficiency and light-emitting effect of the backlight module 20. Light crosstalk between adjacent quantum dot units 31 is further reduced, and an optical angle is reduced.

In the embodiment shown in (c) in FIG. 32, the passivation layer 34 may be prepared on an inner wall of the pixel hole 33 through, but not limited to, an atomic layer deposition process or a sputtering process. A material of the passivation layer 34 may be any one of aluminum oxide (Al₂O₃), aluminum nitride (AlN), silicon dioxide (SiO₂), silicon nitride (SiNx), hafnium oxide (HfO₂), zirconia (ZrO₂), silicon carbon nitride (SiCN), boron nitride (BN), and silicon oxynitride (SiON).

In the embodiment shown in (d) in FIG. 32, in each pixel hole 33, the quantum dot unit 31 may be prepared through a process like spin coating, drip coating, inkjet printing, QD-PR lithography, or QD electrochemical deposition, but this is not limited.

In the embodiment shown in (e) in FIG. 32, after the quantum dot unit 31 is prepared in each pixel hole 33, the buffer layer 13 is prepared on a surface that is of the quantum dot unit 31 and that is away from the backlight module 20, to protect the quantum dot unit 31.

In the embodiment shown in (f) in FIG. 32, after the buffer layer 13 is prepared, the first encapsulation layer 11 is prepared on a surface that is of the buffer layer 13 and that is away from the backlight module 20.

In the embodiment shown in (g) in FIG. 32, after the first encapsulation layer 11 is prepared, the second encapsulation layer 12 is prepared on a surface that is of the first encapsulation layer 11 and that is away from the backlight module 20.

After the buffer layer 13, the first encapsulation layer 11, and the second encapsulation layer 12 are prepared, the encapsulation module 10 is prepared, so that encapsulation protection can be implemented on each functional structure in the display panel 100, and water and oxygen are prevented from eroding each functional structure in the display panel 100. In this way, the display panel 100 can implement good picture display effect.

Finally, the substrate is cut to obtain a plurality of display panels 100 manufactured on a same wafer. A substrate structure in each display panel 100 may be used as the substrate 40. A distance between an edge of the encapsulation module 10 and an edge of the substrate 40 may be understood as a cutting lane width reserved for the substrate during chip-level encapsulation of the display panel 100.

In the embodiment shown in FIG. 32, a possible preparation manner of the display panel 100 is used as an example for description. However, the preparation manner of the display panel 100 is not limited thereto. The preparation manner of the display panel 100 in this application may be adjusted based on an actual requirement. This is not specifically limited in this embodiment of this application.

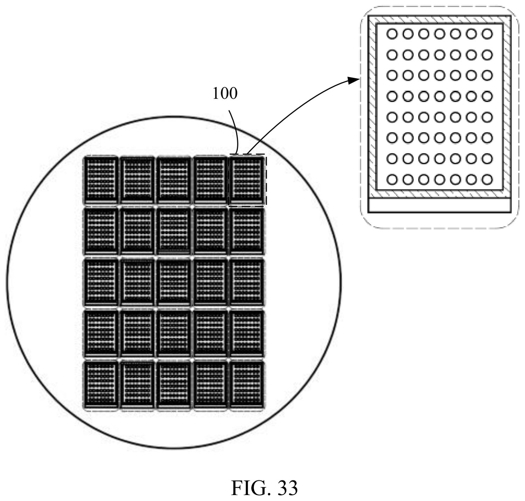

In an embodiment, FIG. 33 is a diagram of a structure from a perspective of a side of the display panel 100 according to an embodiment. In the embodiment shown in FIG. 33, a plurality of display panels 100 are simultaneously prepared and formed on the substrate, and then the encapsulated display panels 100 are cut to form display panels of different sizes. This meets different display requirements of the electronic device 200.

Certainly, the foregoing implementations may be separately used, or may be used in combination. The foregoing descriptions are merely preferred implementations of this application. It should be noted that a person of ordinary skill in the art may make several improvements or polishing without departing from the principle of this application and the improvements or polishing shall fall within the protection scope of this application.

## Claims

1. A display panel, wherein the display panel comprises a substrate, a backlight module, a color conversion module, and an encapsulation module that are sequentially stacked, wherein
the backlight module comprises a plurality of LED light-emitting units that are spaced, and a dimension of each LED light-emitting unit ranges from 1 µm to 50 µm, the color conversion module comprises a plurality of quantum dot units, the plurality of quantum dot units are disposed in a one-to-one correspondence with the plurality of LED light-emitting units, and each quantum dot unit is configured to convert a wavelength of light emitted by a corresponding LED light-emitting unit; and
the encapsulation module comprises an encapsulation layer and a buffer layer, the encapsulation layer covers the color conversion module, the buffer layer is located between the encapsulation layer and the color conversion module, a size of the buffer layer is greater than a size of the plurality of quantum dot units, and the buffer layer is configured to protect the plurality of quantum dot units.

2. The display panel according to claim 1, wherein the encapsulation layer comprises a first encapsulation layer, a size of the first encapsulation layer is greater than the size of the buffer layer, and an edge that is of the first encapsulation layer and that exceeds the buffer layer is attached to the color conversion module.

3. The display panel according to claim 2, wherein the encapsulation module comprises a second encapsulation layer, the second encapsulation layer is attached to a side that is of the first encapsulation layer and that is away from the buffer layer, a size of the second encapsulation layer is greater than the size of the first encapsulation layer, a size of the substrate is greater than a size of the color conversion module, and an edge that is of the second encapsulation layer and that exceeds the first encapsulation layer is attached to the substrate.

4. The display panel according to claim 3, wherein the backlight module comprises a driver backplane, a filling layer, and an electrode layer that are stacked, the filling layer is located between the driver backplane and the electrode layer, the LED light-emitting unit is embedded in the filling layer, a size of the backlight module is greater than the size of the first encapsulation layer, and the edge that is of the second encapsulation layer and that exceeds the first encapsulation layer is further attached to one or more of the driver backplane, the filling layer, and the electrode layer.

5. The display panel according to claim 3 or 4, wherein the color conversion module comprises a quantum dot pixel definition layer, each quantum dot unit is embedded in the quantum dot pixel definition layer, a size of the quantum dot pixel definition layer is greater than the size of the first encapsulation layer, and the edge that is of the second encapsulation layer and that exceeds the first encapsulation layer is further attached to the quantum dot pixel definition layer.

6. The display panel according to claim 2, wherein the encapsulation module comprises a cover assembly, the cover assembly comprises an encapsulation cover and a support ring, the encapsulation cover is spaced from the first encapsulation layer and is located on a side that is of the first encapsulation layer and that is away from the buffer layer, the support ring is disposed around a periphery of the first encapsulation layer and supports the encapsulation cover, and the support ring and the encapsulation cover work together to encapsulate the display panel.

7. The display panel according to claim 6, wherein the support ring is fastened to the color conversion module, the backlight module, or the substrate.

8. The display panel according to any one of claims 2 to 7, wherein the first encapsulation layer is attached to one or more of the color conversion module, the backlight module, and the substrate.

9. The display panel according to any one of claims 2 to 8, wherein in a plane direction of the display panel, a distance between an outer edge of the encapsulation module and an outer edge of the substrate ranges from 50 µm to 150 µm.

10. The display panel according to any one of claims 2 to 9, wherein a material of the first encapsulation layer is one of aluminum oxide, aluminum nitride, zinc oxide, and zirconium oxide.

11. The display panel according to any one of claims 2 to 10, wherein the encapsulation module comprises at least one blocking plate, the blocking plate is disposed around a periphery of the plurality of quantum dot units, and the first encapsulation layer covers the blocking plate.

12. The display panel according to claim 11, wherein the buffer layer is accommodated in the blocking plate, and a thickness of the buffer layer ranges from 30 nm to 5 µm.

13. The display panel according to claim 1, wherein the color conversion module comprises a quantum dot pixel definition layer, a plurality of mutually spaced pixel holes are provided in the quantum dot pixel definition layer, and each quantum dot unit is embedded in one pixel hole; and
a passivation layer is disposed on an inner wall of each pixel hole, and the passivation layer is configured to prevent charge transfer between the quantum dot pixel definition layer and the quantum dot unit.

14. An electronic device, comprising a housing and the display panel according to any one of claims 1 to 13, wherein the display panel is embedded on the housing, and the housing is configured to support and protect the display panel.
